(19) Europäisches Patentamt

European Patent Office

Office européen des brevets

(11) **EP 2 627 151 A1**

(12) **EUROPEAN PATENT APPLICATION**
published in accordance with Art. 153(4) EPC

(43) Date of publication:
**14.08.2013 Bulletin 2013/33**

(21) Application number: **11830670.3**

(22) Date of filing: **04.10.2011**

(51) Int Cl.:
*H05B 33/04* (2006.01)  *G09F 9/30* (2006.01)
*H01L 27/32* (2006.01)  *H01L 51/50* (2006.01)
*H05B 33/02* (2006.01)  *F21Y 105/00* (2006.01)

(86) International application number:
**PCT/JP2011/072885**

(87) International publication number:
**WO 2012/046738 (12.04.2012 Gazette 2012/15)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.10.2010  JP 2010228320**

(71) Applicant: **Sumitomo Chemical Company Limited
Tokyo 104-8260 (JP)**

(72) Inventor: **ONO, Yoshinobu
Niihama-shi
Ehime 792-0015 (JP)**

(74) Representative: **Jackson, Martin Peter
J A Kemp
14 South Square
Gray's Inn
London WC1R 5JJ (GB)**

(54) **ORGANIC EL DEVICE**

(57)     An organic EL device including a first film, a second film disposed facing the first film, and an organic EL element interposed between the first film and the second film. The second film has a gas barrier layer containing silicon atoms, oxygen atoms and carbon atoms. The distribution curve of silicon, the distribution curve of oxygen and the distribution curve of carbon of the gas barrier layer meet the following conditions:

(i) in 90% or more of the region of the gas barrier layer in the thickness direction, the ratio of the number of the silicon atoms being the second largest value,
(ii) the distribution curve of carbon having at least one extremum, and
(iii) the difference between the maximum value and the minimum value of the ratio of the number of the carbon atoms in the distribution curve of carbon being 5 atom% or more.

**Fig.1**

## Description

### Technical Field

The present invention relates to an organic EL device, an illuminating device, a surface light source device and a display device.

### Background Art

An organic EL (Electro Luminescence) element has a configuration in which plural thin films are stacked. By setting appropriately the thickness, the material and the like of the respective thin films, it is possible to give flexibility to the element itself. When providing such an organic EL element on a flexible film, a whole device on which the organic EL element is mounted can become a flexible device.

The organic EL element deteriorates by being exposed to the outside air, and thus, is usually provided on a film having high gas barrier characteristics that is difficult to pass oxygen, moisture and the like therethrough. As films having such high gas barrier characteristics, there is proposed a film formed by depositing, on a plastic base material, a thin film composed of inorganic oxides such as silicon oxide, silicon nitride, silicon nitride oxide and aluminum oxide.

As a method for depositing a thin film composed of an inorganic oxide on a plastic base material, there are known physical vapor deposition (PVD) methods such as a vacuum evaporation method, a sputtering method and an ion plating method, and chemical vapor deposition (CVD) methods such as low pressure chemical vapor deposition and plasma chemical vapor deposition. As a film having high gas barrier characteristics, using such a deposition method, for example, in Japanese Unexamined Patent Application Publication No. 4-89236 (Patent Literature 1), there is disclosed a film having a stacked evaporated film layer formed by stacking two or more layers of evaporated films of a silicon oxide.

In contrast, there is disclosed a film having a ceramic-based inorganic barrier film and a polymer film which are stacked alternately, in Japanese Unexamined Patent Application Publication (Translation of PCT Application) No. 2002-532850 (Patent Literature 2).

### Citation List

### Patent Literature

[Patent Literature 1] Japanese Unexamined Patent Application Publication No. 4-89236
[Patent Literature 2] Japanese Unexamined Patent Application Publication (Translation of PCT Application) No. 2002-532850

### Summary of Invention

### Technical Problem

However, the film described in Patent Literature 1 had problems in which the gas barrier characteristics were not necessarily sufficient and, by being subjected to bending, the gas barrier characteristics lowered.

According to the film described in Patent Literature 2, the enhancement of the gas barrier characteristics, and the suppression of lowering of the gas barrier characteristics caused by bending are expected. However, there was a problem in which the process for manufacturing the film described in Patent Literature 2 was complicated and required long manufacturing time, because of an inorganic barrier film and a polymer film being stacked alternately.

A purpose of the present invention is to provide an organic EL device including a film that is provided with high gas barrier characteristics, has gas barrier characteristics that are difficult to be lowered by bending, and is capable of being formed in a short time by simple process.

### Solution to Problem

The present invention relates to an organic EL element including a first film, a second film disposed facing the first film, and an organic EL element disposed between the first film and the second film. The second film seals the organic EL element in conjunction with the first film. The second film has a gas barrier layer containing silicon (silicon atoms), oxygen (oxygen atoms) and carbon (carbon atoms). A distribution curve of silicon, a distribution curve of oxygen and a distribution curve of carbon each showing the relationship between the ratio of the amount (number) of the silicon atoms (the atomic ratio of the silicon), the ratio of the amount (number) of the oxygen atoms (the atomic ratio of the oxygen) and the ratio (number) of the carbon atoms (the atomic ratio of the carbon) relative to the total amount of silicon atoms, oxygen atoms and carbon atoms, and the distance from one surface of the gas barrier layer in the thickness direction (in the film thickness direction) of the gas barrier layer, meets the following conditions (i) to (iii).

(i) In 90% or more of the region of the gas barrier layer in the thickness direction (film thickness direction), the atomic ratio of silicon is the second largest value among the atomic ratio of silicon, the atomic ratio of oxygen and the atomic ratio of carbon.
(ii) The distribution curve of carbon has at least one extremum.
(iii) The absolute value of the difference between the maximum value and the minimum value of the atomic ratio of the carbon in the distribution curve of carbon is 5 atom% (at%) or more.

The first film may be a metallic film.

The first film may have a second gas barrier layer containing silicon, oxygen and carbon. The distribution curve of silicon, the distribution curve of oxygen and the distribution curve of carbon of the second gas barrier layer according to an embodiment meet the conditions (i), (ii) and (iii).

In another aspect, the present invention relates to an illuminating device, a surface light source device and a display device having the organic EL device.

**Advantageous Effects of Invention**

According to the present invention, it is possible to realize an organic EL device including a film that is provided with high gas barrier characteristics, has gas barrier characteristics hardly lowered by bending, and is capable of being formed in a short time by a simple process.

**Brief Description of Drawings**

Fig. 1 is a cross-sectional view showing an organic EL device according to an embodiment.
Fig. 2 is a cross-sectional view showing an organic EL device according to an embodiment.
Fig. 3 is a conceptual view showing an embodiment of an apparatus for manufacturing an organic EL device.
Fig. 4 is a schematic view showing an embodiment of an apparatus manufacturing a second film.
Fig. 5 is a graph showing a distribution curve of silicon, a distribution curve of oxygen and a distribution curve of carbon in a second film obtained in a reference example A1.
Fig. 6 is a graph showing the distribution curve of silicon, the distribution curve of oxygen, the distribution curve of carbon and a distribution curve of oxygen-carbon in the second film obtained in the reference example A1.
Fig. 7 is a graph showing the distribution curve of silicon, the distribution curve of oxygen, the distribution curve of carbon and the distribution curve of oxygen-carbon in the second film obtained in a reference example A2.
Fig. 8 is a graph showing the distribution curve of silicon, the distribution curve of oxygen, the distribution curve of carbon and the distribution curve of oxygen-carbon in the second film obtained in a reference example A2.
Fig. 9 is a graph showing the distribution curve of silicon, the distribution curve of oxygen, and the distribution curve of carbon in the second film obtained in a reference example A3.
Fig. 10 is a graph showing the distribution curve of silicon, the distribution curve of oxygen, the distribution curve of carbon and the distribution curve of oxygen-carbon in the second film obtained in a reference example A3.
Fig. 11 is a graph showing the distribution curve of silicon, the distribution curve of oxygen and the distribution curve of carbon in the second film obtained in a reference comparative example A1.
Fig. 12 is a graph showing the distribution curve of silicon, the distribution curve of oxygen, the distribution curve of carbon and the distribution curve of oxygen-carbon in the second film obtained in a reference comparative example A1.

Description of Embodiments

Hereinafter, favorable embodiments of the present invention will be described in detail. However, the present invention is not limited to the following embodiments.

The organic EL device according to the present embodiment has a first film, an organic EL element, and a second film that is disposed on the first film with the organic EL element interposed between the first film and the second film, and that seals the organic EL element in conjunction with the first film. That is, the second film is disposed facing the first film, and the organic EL element is interposed between the first film and the second film.

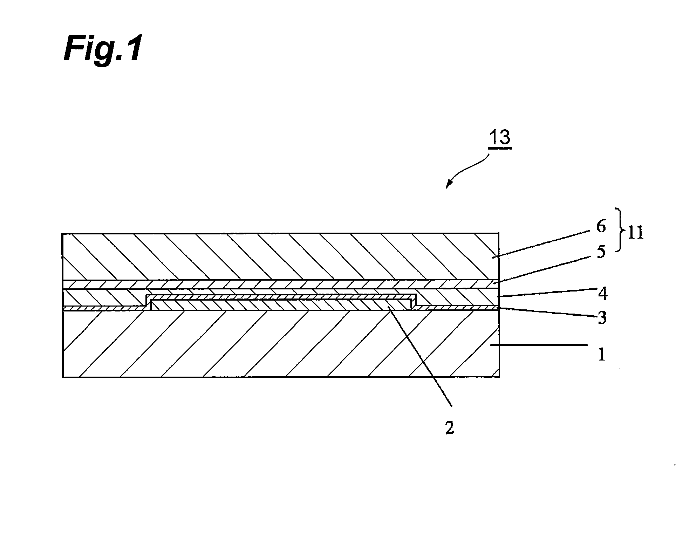

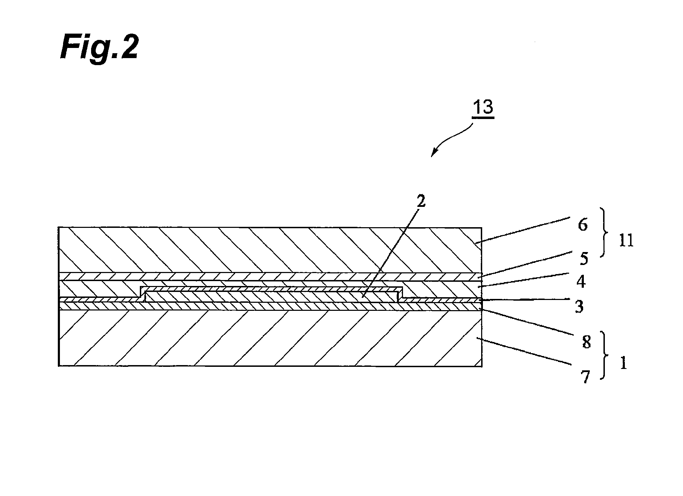

It is possible to classify roughly the organic EL element to be mounted on the organic EL device into elements of following three types. That is, it is possible to classify roughly the organic EL element into (I) an element of what is called a bottom emission type, which emits light toward a support substrate on which the organic EL element is mounted, (II) an element of what is called a top emission type, which emits light toward the side opposite the support substrate, and (III) an element of double-side light emission type, which emits light toward the support substrate and emits light toward the side opposite to the support substrate. The organic EL element to be mounted on the organic EL device according to the present embodiment may be an element of any type. In the following, as an example, first, with reference to Fig. 1, an organic EL device provided with the element of top emission type will be explained, and next, with reference to Fig. 2, an organic EL device provided with the element of bottom emission type will be explained.

Fig. 1 is a cross-sectional view showing schematically the organic EL device of the present embodiment. In an organic EL device 13 of the embodiment shown in Fig. 1, on a first film 1, an organic EL element 2 is mounted. A second film 11 is disposed on the first film 1, with the organic EL element 2 interposed between the first film 1. The second film 11 seals the organic EL element 2 in conjunction with the first film 1. The first film 1 and the second film 11 are bonded together via an adhesion layer 4 provided therebetween. The organic EL device 13 may include, if necessary, a protective layer 3 that covers the organic EL element 2 and is interposed between the organic EL element 2 and the adhesion layer 4. By providing the protective layer 3, it is possible to protect the organic EL element 2 from the adhesion layer 4.

The organic EL element 2 of the present embodiment shown in Fig. 1 is an element of top emission type, and emits light toward the second film 11. Therefore, the second film 11 is necessary to be formed with a member that allows light to pass through. In contrast, the first film 1 corresponding to the support substrate in the present embodiment may be formed with an opaque member that does not allow light to pass through.

It is possible to use a plastic film or a metallic film as the first film 1, and the metallic film is preferable. The metallic film has high gas barrier characteristics as compared with plastic films and the like and thus, can enhance gas barrier characteristics of the organic EL device. As the metallic film, for example, it is possible to use a thin plate of Al, Cu or Fe, and a thin plate of an alloy such as stainless steel.

The second film 11 has a gas barrier layer 5 containing silicon atoms, oxygen atoms and carbon atoms. In the present embodiment, the second film 11 includes a base material 6, and the gas barrier layer 5 provided on the main surface on the organic EL element 2 side of the base material 6. The gas barrier layer 5, by meeting conditions (i), (ii) and (iii) to be described later, includes high gas barrier characteristics, and furthermore, can suppress the lowering of the gas barrier characteristics when subjected to bending.

By sealing the organic EL element 2 with these first film 1 and second film, it is possible to realize the organic EL device that is flexible and has both sufficient durability and gas barrier characteristics. In particular, when the metallic film is used as the first film 1, both the first film 1 and the second film 11 show high gas barrier characteristics, and thus it is possible to realize the organic EL device having both higher durability and gas barrier characteristics.

Fig. 2 is a cross-sectional view showing schematically an organic EL device 13 of another embodiment. The organic EL device 13 of the embodiment shown in Fig. 2 differs from the embodiment shown in Fig. 1 in the organic EL element and the first film 1. The organic EL element 2 of the present embodiment is the element of bottom emission type, and emits light toward the first film 1 corresponding to the support substrate. Therefore, it is necessary that the first film 1 is a film exhibiting optical transparency.

The first film 1 of the present embodiment is not particular limited as long as it is a film exhibiting optical transparency, and, from the viewpoint of gas barrier characteristics, has preferably the second gas barrier layer 8 containing silicon atoms, oxygen atoms and carbon atoms, in the same manner as the second film 11. In the present embodiment, the first film 1 is composed of a base material 7, and the second gas barrier layer 8 provided on the main surface on the organic EL element 2 side of the base material 7. The second gas barrier layer 8, in the same manner as the gas barrier layer 5 of the second film 11, by meeting conditions (i), (ii) and (iii) to be described later, includes high gas barrier characteristics, and furthermore, can suppress the lowering of gas barrier characteristics when subjected to bending.

Also by sealing the organic EL element 2 with these first film 1 and second film, it is possible to realize the organic EL element 2 that is flexible and has both sufficient durability and gas barrier characteristics.

In the organic EL device of the embodiment shown in Fig. 2, in place of the organic EL element of bottom emission type, it is also possible to provide the organic EL element of double-side light emission type.

By using the first film as a sealing member, and by using the second film having the gas barrier layer as the support substrate, the organic EL element may be sealed by the first film and the second film.

For example, in embodiments shown in Fig. 1 and Fig. 2, to the first film and/or the second film, an additional film may furthermore be bonded. Additional films include a protective film protecting the surface of the organic EL device, an antireflection film preventing the reflection of outside light entering the organic EL device, a light extraction film having a function of enhancing light extraction efficiency, an optical functional film for adjusting phase and polarization of light, optical films having a configuration in which plural films selected from these are stacked, and the like. The additional film is bonded to one surface or both surfaces of the first film and/or the second film.

Adhesion layer

The adhesion layer is a layer that causes the first film and the second film to adhere in a state where the organic EL element is disposed between these. It is preferable that an adhesive to be used in the adhesion layer has high gas barrier characteristics. In the organic EL device as shown in Fig. 1, in which light emitted from the organic EL element 2 is emitted to the outer world through an adhesion layer 4, it is preferable that the light transmittance of the adhesion layer 4 is high. In this case, from the viewpoint of the light extraction efficiency, it is preferable that the absolute value of difference in refractive indices of the layer in contact with the adhesion layer 4 and the adhesion layer 4 is as small as possible.

As the adhesive utilizable in the adhesion layer, a curable adhesive such as a heat-curable adhesive and a photo-curable adhesive is favorable.

The heat-curable resin adhesive includes an epoxy-based adhesive, and an acrylate-based adhesive and the like.

Examples of the epoxy-based adhesive include an adhesive containing an epoxy compound selected from bisphenol A type epoxy resin, a bisphenol F type epoxy resin and a phenoxy resin.

Examples of the acrylate-based adhesive include adhesives containing a monomer as a main component selected from acrylic acid, methacrylic acid, ethyl acrylate, butyl acrylate, 2-hexyl acrylate, acrylamide, acrylonitrile, hydroxyl acrylate, and the like, and containing a monomer capable of copolymerization with the main component.

The photo-curable adhesive includes a radical-based adhesive and a cation-based adhesive, and the like.

The radical-based adhesive includes an epoxy acrylate, an ester acrylate, an adhesive containing an ester acrylate, and the like.

The cation-based adhesive includes an adhesive containing an epoxy-based resin, a vinyl ether-based resin and the like.

Protective layer

The protective layer is provided so as to cover the organic EL element. By providing the protective layer, it is possible to protect the organic EL element from the adhesion layer.

An electron injection layer and a cathode including the organic EL element contain, as a major component, usually, a material that is unstable in the air, and thus, during the period after the formation of an organic EL element until the organic EL element is sealed by bonding the second film, there is a risk of deterioration of the electron injection layer and the cathode by moisture, oxygen and the like in an atmosphere. Accordingly, it is preferable that the protective layer has a function of blocking off the moisture, oxygen and the like in the atmosphere and of protecting the organic EL element from these, during the period until the organic EL element is sealed by the second film.

Materials for use in the protective layer include metal materials stable in the air, inorganic insulating materials, organic insulating materials excellent in barrier characteristics and the like. The metal material is selected, for example, from Al, Cu, Ag, Au, Pt, Ti, Cr, Co and Ni. The inorganic insulating material is selected, for example, from $SiO_2$, SiN, $SiO_xN_y$ and $SiO_xC_y$. As the organic insulating material, parylene and the like are used.

The protective layer formed from the metal material is formed, for example, by a vacuum evaporation method, a sputtering method, or a plating method. The protective layer formed from the inorganic insulating material is formed, for example, by a sputtering method, a CVD method, or a laser ablation method. The protective layer formed from the organic insulating material is formed, for example, by a film-forming method including a vacuum evaporation of monomer gas, and polymerization at the evaporated film (surface to be coated) containing the monomer.

Method for manufacturing organic EL device

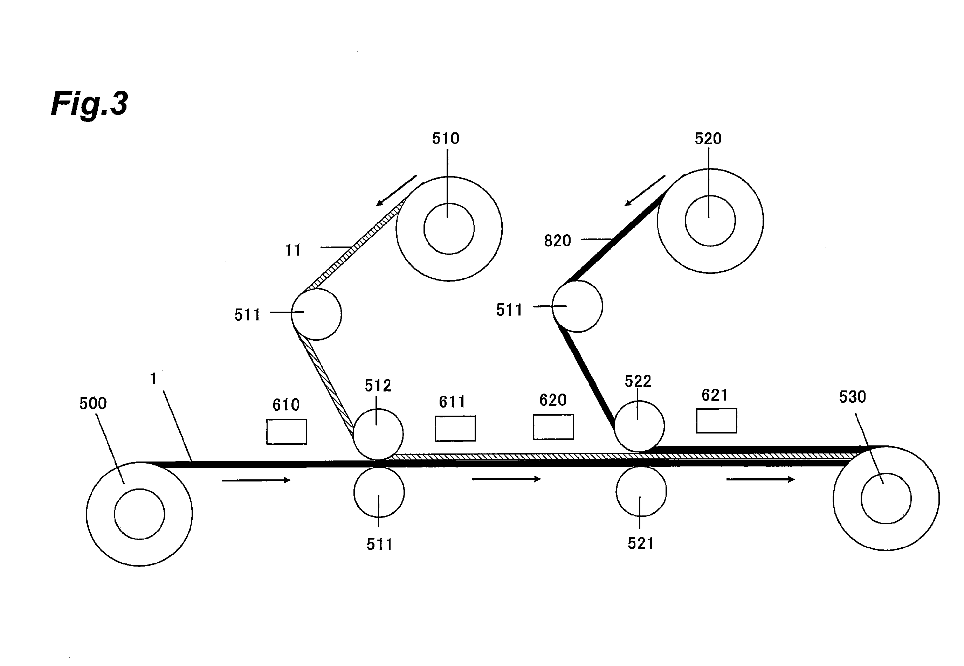

Hereinafter, a method for manufacturing the organic EL device will be described with reference to Fig,. 3. Fig. 3 is a drawing showing roughly an apparatus manufacturing the organic EL device. In the apparatus shown in Fig. 3, the first film 1 and the second film 11s are bonded together, and, furthermore, an additional film 820 is bonded to the second film 11. On the first film 1, the organic EL element has been formed previously.

An unwinding roll 500 sends out the first film 1 on which the organic EL element has been formed previously. The unwinding roll 510 sends out the second film 11. On the first film 1 sent out from the unwinding roll 500, an adhesive is coated by a coating apparatus 610 for a first adhesion layer, and the first adhesion layer is formed. After that, by first bonding rolls 511 and 512, the first film 1 and the second film 11 that has been supplied through a conveying roll 513 are bonded together via the first adhesion layer, and furthermore, by a curing apparatus 611 for the first adhesion layer, the first adhesion layer is cured (solidified).

On the second film 11, an adhesive is coated by a coating apparatus 620 for a second adhesion layer provided on the downstream side of the curing apparatus 611, and the second adhesion layer is further formed. Subsequently, by second bonding rolls 521 and 522, there are bonded together the second film 11 and the additional film 820 that has been sent out from the unwinding roll 520 and that has been supplied through a conveying roll 523 via the second adhesion layer, and, furthermore, by a curing apparatus 621 for the second adhesion layer, the second adhesion layer is cured (solidified). After that, the formed organic EL device is wound by a winding roll 530.

As the additional film, for example, the aforementioned film is used. In the present embodiment, one additional film is bonded, but two or more additional films may be bonded sequentially. When three or more films are to be bonded, the order of the bonding is appropriately changed depending on the stacking order of the organic EL device.

Second film

Next, the second film 11 will be described. One of characteristics of the organic EL device of the present embodiment lies in the second film, in particular, in the gas barrier layer 5 thereof.

The second film has a gas barrier layer containing silicon atoms, oxygen atoms and carbon atoms. By measuring the ratio of the number of the silicon atoms (the atomic ratio of silicon), the ratio of the number (amount) of the oxygen atoms (the atomic ratio of oxygen) and the ratio of the number of the carbon atoms (the atomic ratio of carbon) relative to the total amount of silicon atoms, oxygen atoms and carbon atoms, while changing the distance from one surface of the gas barrier layer in the thickness direction of the gas barrier layer, it is possible to obtain the distribution curve of silicon, the distribution curve of oxygen and the distribution curve of carbon, each showing the relationship between the atomic ratio of each of atoms and the distance from the surface of the gas barrier layer. These curves obtained from the gas barrier layer according to the present embodiment meet the following conditions (i), (ii) and (iii).

(i) In 90% or more of the region of the gas barrier layer in the thickness direction, the atomic ratio of silicon is the second largest value among the atomic ratio of silicon, the atomic ratio of oxygen and the atomic ratio of carbon.
(ii) The distribution curve of carbon has at least one extremum.
(iii) The difference (the absolute value) between the maximum value and the minimum value of the atomic ratio of the carbon in the distribution curve of carbon is 5 at% or more.

The condition of (i) means, in other words, that, in 90% or more of the region of the gas barrier layer in the thickness direction, the following formula (1) or (2) is met.

$$(\text{atomic ratio of oxygen}) > (\text{atomic ratio of silicon}) > (\text{atomic ratio of carbon}) \dots(1)$$

$$(\text{atomic ratio of carbon}) > (\text{atomic ratio of silicon}) > (\text{atomic ratio of oxygen}) \dots(2)$$

Base material of second film

The above-mentioned gas barrier layer is formed, usually, on a base material. That is, the second film includes the base material, and the gas barrier layer formed on the base material. Examples of the base material of the second film includes a colorless and transparent resin film or resin sheet. The resin to be used for the base material like this is selected, for example, from polyester-based resins such as polyethylene terephthalate (PET) and polyethylene naphthalate (PEN); polyolefin-based resins such as polyethylene (PE), polypropylene (PP) and a cyclic polyolefin; a polyamide-based resin; a polycarbonate-based resin; a polystyrene-based resin; a polyvinyl alcohol-based resin; a saponified ethylene-vinyl acetate copolymer; a polyacrylonitrile-based resin; an acetal-based resin; and a polyimide-based resin. Among these resins, from the viewpoint that heat resistance is high, a coefficient of linear thermal expansion is small, and manufacturing cost is low, a polyester-based resin and a polyolefin-based resin are preferable, and PET and PEN are particularly preferable. These resins may be used in one kind alone, or in a combination of two or more kinds.

It is possible to set appropriately the thickness of the base material of the second film, in consideration of the stability in manufacturing the second film. It is preferable that, from the view point that the conveyance of the film is possible in vacuum, the thickness of the base material of the second film is in the range of 5 to 500 μm. When the gas

barrier layer is formed by a plasma CVD method, since the gas barrier layer is formed while discharge is performed through the base material of the second film, it is preferable that the thickness of the base material of the second film is 50 to 200 $\mu$m, and is further preferable that the thickness is 50 to 100 $\mu$m.

From the viewpoint of adherence to the gas barrier layer to be described later, it is preferable to subject the base material of the second film to a surface activation treatment for cleaning the surface. Examples of such surface activation treatments include a corona treatment, a plasma treatment, and a flame treatment.

Gas barrier layer

The gas barrier layer is formed on at least one surface of the base material. It is sufficient that the second film according to the present embodiment includes the gas barrier layer that contains, in at least one layer, silicon atoms, oxygen atoms and carbon atoms and that meets all the above conditions (i) to (iii). For example, the second film may have another layer that does not meet at least any of the above conditions (i) to (iii). The gas barrier layer or the other layer may further contain nitrogen atoms, aluminum atoms and the like.

When the atomic ratio of silicon, the atomic ratio of oxygen and the atomic ratio of carbon do not meet the above condition (i), the gas barrier characteristics of the second film lower. It is preferable that the region meeting the formula (1) or (2) occupies 90% or more of the thickness of the gas barrier layer. The ratio is more preferably 95% or more, further preferably 100%.

It is necessary that, in the gas barrier layer according to the present embodiment, as the above condition (ii), the distribution curve of carbon has at least one extremum. In the gas barrier layer, it is more preferable that the distribution curve of carbon has two extrema, and it is further preferable to have three or more extrema. In the case where the distribution curve of carbon does not have an extremum, gas barrier characteristics lower when the second film to be obtained is bent. In the case where the distribution curve of carbon has at least three extrema, it is preferable that the distance between neighboring extrema of the distribution curve of carbon in the thickness direction is 200 nm or less, and it is more preferable that the distance is 100 nm or less.

In the present description, the extremum denotes a relative maximum value or a relative minimum value in the distribution curve obtained by plotting the atomic ratio of an element for the distance from the surface of the gas barrier layer in the thickness direction of the gas barrier layer. The relative maximum value denotes the atomic ratio of an element at a point, in the above distribution curve, at which the value of the atomic ratio of the element changes from increase to decrease along with the change of the distance from the surface of the gas barrier layer, and, at the point the value of the atomic ratio of the element at a position at which the distance from the surface of the gas barrier layer in the thickness direction of the gas barrier layer from the point has further changed by 20 nm, decreases by 3 at% or more in comparison with the value of the atomic ratio of the element at the point. The relative minimum value denotes the atomic ratio of an element at a point, in the above distribution curve, at which the value of the atomic ratio of the element changes from decrease to increase along with the change of the distance from the surface of the gas barrier layer, and, at the point the value of the atomic ratio of the element at a position at which the distance from the surface of the gas barrier layer in the thickness direction of the gas barrier layer from the point has further changed by 20 nm, increases by 3 at% or more in comparison with the value of the atomic ratio of the element at the point.

It is necessary that, in the gas barrier layer according to the present embodiment, as the above condition (iii), the difference between the maximum value and the minimum value of the atomic ratio of the carbon in the distribution curve of carbon is 5 at% or more. In the gas barrier layer, it is more preferable that the difference between the maximum value and the minimum value of the atomic ratio of the carbon is 6 at% or more, and it is further more preferable that the difference is 7 at% or more. When this difference is less than 5 at%, when the second film is subjected to bending, the gas barrier characteristics of the second film lower. The upper limit of the difference is, although not particularly limited, usually, approximately 30 at%.

Distribution curve of oxygen, extremum

It is preferable that the distribution curve of oxygen of the gas barrier layer has at least one extremum, is more preferable that the curve has at least two extrema, and is furthermore preferable that curve has at least three extrema. In the case where the distribution curve of oxygen has the extremum, there is such a tendency that the lowering in the gas barrier characteristics by bending of the second film is further hard to be caused. In the case where the distribution curve of oxygen of the gas barrier layer has at least three extrema, it is preferable that, between one extremum the distribution curve of oxygen has and extrema neighboring the extremum, all of the differences in each of the distances from the surface of the gas barrier layer in the thickness direction of the gas barrier layer are 200 nm or less, and is more preferable that all of the differences are 100 nm or less.

Distribution curve of oxygen, difference between the maximum value and the minimum value

It is preferable that the difference between the maximum value and the minimum value of the atomic ratio of the oxygen in the distribution curve of oxygen of the gas barrier layer is 5 at% or more, it is more preferable that the difference is 6 at% or more, and it is further more preferable that the difference is 7 at% or more. When the difference is not less than the lower limit, the lowering of the gas barrier characteristics of the second film by bending tends to be further difficult to be caused. The upper limit of the difference is not particularly limited, but it is usually approximately 30 at%.

It is preferable that the difference between the maximum value and the minimum value of the atomic ratio of silicon in the distribution curve of silicon of the gas barrier layer is preferably less than 5 at%, is more preferable that the difference is less than 4 at%, and is further more preferable that the difference is less than 3 at%. When the difference is less than the upper limit, the gas barrier characteristics of the second film tend to be particularly high.

Distribution curve of oxygen-carbon, difference between the maximum value and the minimum value

In the distribution curve of oxygen-carbon showing the relationship between the distance from the surface of the layer in the thickness direction of the gas barrier layer and the ratio of the total amount of oxygen atoms and carbon atoms (atomic ratio of oxygen and carbon) relative to the total amount of silicon atoms, oxygen atoms and carbon atoms, it is preferable that the difference between the maximum value and the minimum value of the total of atomic ratios of oxygen and carbon is less than 5 at%, is more preferable that the difference is less than 4 at%, and is furthermore preferable that the difference is less than 3 at%. When the difference is less than the upper limit, the gas barrier characteristics of the second film tend to be particularly high.

It is possible to create the distribution curve of silicon, the distribution curve of oxygen, the distribution curve of carbon and the distribution curve of oxygen-carbon by what is called XPS depth profile measurement, in which surface composition analysis is sequentially performed while the inside of a sample is exposed by the use of both the measurement of X-ray photoelectron spectroscopy (XPS) and ion sputtering of rare gas such as argon. It is possible to create the distribution curve obtained by such XPS depth profile measurement, for example, by designating the ordinate as the atomic ratio (unit: at%) of each element and the abscissa as etching time (sputtering time). The etching time generally is correlated to the distance from the surface of the gas barrier layer in the thickness direction of the gas barrier layer. Accordingly, it is possible to adopt the distance form the surface of the gas barrier layer calculated from the relationship between the etching speed adopted in the XPS depth profile measurement and etching time, as "the distance from one surface of the gas barrier layer in the thickness direction of the gas barrier layer." In the sputtering method adopted at the time of the XPS depth profile measurement, it is preferable to adopt a rare gas ion sputtering method using argon ($Ar^+$) as etching ion species and to set the etching speed (etching rate) thereof to be 0.05 nm/sec (in terms of a $SiO_2$ thermally-oxidized film).

From the viewpoint of forming a gas barrier layer having uniform and excellent gas barrier characteristics in the whole film plane, it is preferable that the gas barrier layer is substantially uniform in the film plane direction (in the direction parallel to the main face (surface) of the gas barrier layer). In the present description, "the gas barrier layer is substantially uniform in the film plane direction" denotes that, when creating the distribution curve of oxygen, distribution curve of carbon and distribution curve of oxygen-carbon for arbitrary two measurement places in the film plane of the gas barrier layer by XPS depth profile measurement, the numbers of extrema, which the distribution curve of carbon obtained at the arbitrary two measurement places has, are the same as each other and the difference between the maximum value and the minimum value of the atomic ratio of carbon in each of the distribution curve of carbon is the same as each other or the difference thereof is 5 at% or less.

It is preferable that the distribution curve of carbon is substantially continuous. In the description, "the distribution curve of carbon is substantially continuous" means that the curve does not include a part in which the atomic ratio of the carbon in the distribution curve of carbon changes discontinuously. Specifically, this denotes that, in the relationship between the distance (x, unit: nm) from the surface of the layer in the thickness direction of the gas barrier layer calculated from an etching speed and etching time and the atomic ratio of the carbon (c, unit: at%), the condition represented by the following formula (F1):

$$-1.0 \leq (dc/dx) \leq 1.0 \ldots (F1)$$

is met.

It is sufficient that the second film according to the present embodiment includes at least one gas barrier layer that meets all the above conditions (i) to (iii), and the second film may include the gas barrier layers that meet all the above conditions (i) to (iii) in two or more layers. When the second film includes such gas barrier layers in two or more layers, the material quality of plural gas barrier layers may be the same or different from each other. In addition, when the second film includes such gas barrier layer in two or more layers, these gas barrier layers may be formed on one surface of the base material, or each may be formed on both surfaces of the base material. The second film may include a thin film layer not necessarily having gas barrier characteristics.

In the distribution curve of silicon, the distribution curve of oxygen and the distribution curve of carbon, when the atomic ratio of silicon, the atomic ratio of oxygen and the atomic ratio of carbon meet the condition shown by the formula (1), it is preferable that the atomic ratio of the content of the silicon atoms relative to the total amount of the silicon atoms, oxygen atoms and carbon atoms in the gas barrier layer is 25 to 45 at%, is more preferable that the ratio is 30 to 40 at%. It is preferable that the atomic ratio of the content of the oxygen atoms relative to the total amount of the silicon atoms, oxygen atoms and carbon atoms in the gas barrier layer is 33 to 67 at%, and is more preferable that the ratio is 45 to 67 at%. It is preferable that the atomic ratio of the content of the carbon atoms relative to the total amount of the silicon atoms, oxygen atoms and carbon atoms in the gas barrier layer is 3 to 33 at%, and is more preferable that the ratio is 3 to 25 at%.

In the distribution curve of silicon, the distribution curve of oxygen and the distribution curve of carbon, when the atomic ratio of silicon, the atomic ratio of oxygen and the atomic ratio of carbon meet the condition shown by the formula (2), it is preferable that the atomic ratio of the content of the silicon atoms relative to the total amount of the silicon atoms, oxygen atoms and carbon atoms in the gas barrier layer is 25 to 45 at%, and is more preferable that the ratio is 30 to 40 at%. It is preferable that the atomic ratio of the content of the oxygen atoms relative to the total amount of the silicon atoms, oxygen atoms and carbon atoms in the gas barrier layer is 1 to 33 at%, and is more preferable that the ratio is 10 to 27 at%. It is preferable that the atomic ratio of the content of the carbon atoms relative to the total amount of the silicon atoms, oxygen atoms and carbon atoms in the gas barrier layer is 33 to 66 at%, and is more preferable that the ratio is 40 to 57 at%.

It is preferable that the thickness of the gas barrier layer is 5 to 3000 nm, is more preferable that the thickness is 10 to 2000 nm, and is particularly preferable that the thickness is 100 to 1000 nm. When the thickness of the gas barrier layer is in the range of these numerical values, more excellent gas barrier characteristics such as oxygen gas barrier characteristics and moisture barrier characteristics tend to be obtained, and the lowering of gas barrier characteristics by bending tends to be further effectively suppressed.

When the second film includes pural gas barrier layers, the total value of the thicknesses of the gas barrier layers is usually 10 to 10000 nm, and it is preferable that the value is 10 to 5000 nm, is more preferable that the value is 100 to 3000 nm, and is further more preferable that the value is 200 to 2000 nm. When the total value of the thicknesses of the gas barrier layers is in the range of these numerical values, there is a tendency that more excellent gas barrier characteristics such as oxygen gas barrier characteristics and moisture barrier characteristics is obtained, and the lowering of gas barrier characteristics by bending is further more effectively suppressed.

The second film may include further, in addition to the base material and the gas barrier layer of the second film, if necessary, a primer coat layer, a heat-sealing resin layer, an adhesive layer etc. It is possible to form the primer coat layer by using a primer coating agent capable of enhancing the adhesiveness to the base material and the gas barrier layer. It is possible to form the heat-sealing resin layer by using appropriately a known heat-sealing resin. It is possible to form the adhesive layer using appropriately an ordinary adhesive, and plural second films may adhere to each other by the adhesive layer.

It is preferable that the gas barrier layer of the second film is a layer formed by a plasma chemical vapor deposition method. It is more preferable that the gas barrier layer formed by a plasma chemical vapor deposition method is a layer formed by a plasma chemical vapor deposition method of disposing the base material of the second film on a pair of deposition rolls and discharging between the pair of deposition rolls to generate plasma. When discharging between the pair of deposition rolls, it is preferable to reverse alternately polarities of the pair of deposition rolls. It is preferable that a deposition gas used for the plasma chemical vapor deposition method contains an organosilicon compound and oxygen. It is preferable that the content of oxygen in the deposition gas is a theoretical oxygen amount necessary for oxidizing completely the whole amount of the organosilicon compound in the deposition gas or less. It is preferable that the gas barrier layer of the second film is a layer formed by a continuous deposition process. Details of the method for forming the gas barrier layer by utilizing the plasma chemical vapor deposition method will be explained in a method for manufacturing the second film described later.

Method for manufacturing second film

Next, a method for manufacturing the second film will be described. It is possible to manufacture the second film by forming the gas barrier layer on the surface of the base material of the second film. As a method for forming the gas barrier layer on the surface of the base material of the second film, from the viewpoint of gas barrier characteristics, plasma chemical vapor deposition method (plasma CVD) is preferable. The plasma chemical vapor deposition method may be plasma chemical vapor deposition method of a Penning discharge plasma system.

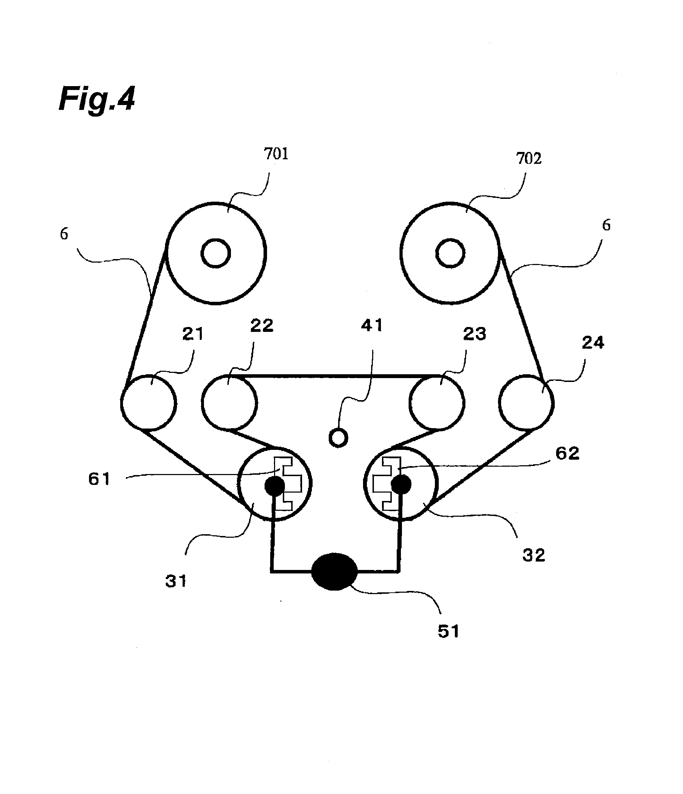

When generating plasma in the plasma chemical vapor deposition method, it is preferable to generate plasma discharge in a space between a plurality of deposition rolls, and it is more preferable to generate plasma by using a pair of deposition rolls, disposing the base material for each of the pair of deposition rolls, and discharging between the pair of deposition rolls. By using a pair of deposition rolls in this manner, it is possible, at the time of deposition, while depositing the gas barrier layer on the base material existing on one deposition roll, to deposit, at the same time, the gas barrier layer also on the base material existing on the other deposition roll. Consequently, it is not only possible to manufacture effectively the gas barrier layer, but also to deposit, at the same time, the films of the same structure at a doubled deposition rate. As the result, it becomes possible to form effectively the gas barrier layer meeting all the above conditions (i) to (iii), while at least doubling the extremum in the distribution curve of carbon. From the viewpoint of the productivity, it is preferable to form the gas barrier layer on the surface of the base material of the second film. by a roll-to-roll system. Although an apparatus that can be used when manufacturing the second film by the plasma chemical vapor deposition method is not particularly limited, it is preferable that the apparatus is one that includes at least a pair of deposition rolls and a plasma power source, and can discharge between the pair of deposition rolls. For example, by using a manufacturing apparatus shown in Fig. 4, it may be possible to manufacture the second film by a roll-to-roll system while utilizing a plasma chemical vapor deposition method.

Hereinafter, while referring to Fig. 4, the method for manufacturing the second film will be described in more detail. Fig. 4 is a schematic view showing an example of a manufacturing apparatus capable of being preferably utilized for manufacturing the second film according to the present embodiment. In the following description and drawings, the same reference sign is given to the same or corresponding elements, and the overlapping description is appropriately omitted.

The manufacturing apparatus shown in Fig. 4 includes a feeding roll 701, conveying rolls 21, 22, 23 and 24, a pair of deposition rolls 31 and 32 disposed facing each other, a gas supply pipe 41, a power source 51 for generating plasma, magnetic field-generating devices 61 and 62 placed inside the deposition rolls 31 and 32, and a winding roll 702. In the manufacturing apparatus, at least the deposition rolls 31 and 32, the gas supply pipe 41, the power source 51 for generating plasma, and the magnetic field-generating devices 61 and 62 are disposed in a vacuum chamber, which is not shown. The vacuum chamber is connected to a vacuum pump, which is not shown, and, with the vacuum pump, it may be possible to adjust appropriately the pressure in the vacuum chamber.

In the manufacturing apparatus in Fig. 4, so that it becomes possible to cause a pair of deposition rolls (deposition roll 31 and deposition roll 32) to function as a pair of counter electrodes, each of deposition rolls are connected respectively to the power source 51 for generating plasma. By supplying electric power from the power source 51 for generating plasma, it is possible to discharge in the space between the deposition roll 31 and the deposition roll 32 and to thereby generate plasma in the space between the deposition roll 31 and the deposition roll 32. In the case of utilizing the deposition roll 31 and the deposition roll 32 also as electrodes, it is sufficient to change appropriately the material and design so that they are utilizable as electrodes. It is preferable that the pair of deposition rolls (deposition rolls 31 and 32) are disposed so that central axes thereof become substantially parallel on the same plane. By disposing the pair of deposition rolls (deposition rolls 31 and 32) in this manner and depositing the gas barrier layer on each of the deposition rolls, in comparison with the case of performing the deposition on one deposition roll, it is possible to double the deposition rate, and yet, since it is possible to deposit films of the same structure in piles, it is possible to at least double the number of extrema in the distribution curve of carbon. According to the manufacturing apparatus like this, it is possible to form the gas barrier layer on the surface of the base material 6 by a CVD method, and it is also possible, while accumulating film components on the surface of the base material 6 on the deposition roll 31, to further accumulate film components on the surface of the base material 6 also on the deposition roll 32. Consequently, it is possible to form effectively the gas barrier layer on the surface of the base material 6.

Inside the deposition roll 31 and the deposition roll 32, the magnetic field-generating devices 61 and 62 are provided. The magnetic field-generating devices 61 and 62 are fixed so as not to rotate themselves even if the deposition rolls rotate.

It is possible, as the deposition roll 31 and the deposition roll 32, to use appropriately an ordinary roll. It is preferable that diameters of the deposition rolls 31 and 32 are, from the viewpoint of forming more effectively a thin film, substantially the same. It is preferable that the diameters of the deposition rolls 31 and 32 are 5 to 100 cm, from the viewpoint of discharge conditions, space of chamber and the like.

In the manufacturing apparatus in Fig. 4, so that the surfaces of base materials 6 face each other, on the pair of deposition rolls (deposition roll 31 and deposition roll 32), the base materials 6 are disposed. By disposing the base material 6 in this manner, it is possible, when discharging between the deposition roll 31 and the deposition roll 32 to generate plasma, to perform deposition simultaneously for each surface of the base materials 6 existing between the pair of deposition rolls. That is, according to such manufacturing apparatus, it is possible, by a CVD method, to accumulate film components on the surface of the base material 6 on the deposition roll 31, and, furthermore, to accumulate film components on the deposition roll 32. Consequently, it is possible to form effectively the gas barrier layer on the surface of the base material 6.

As the feeding roll 701 and conveying rolls 21, 22, 23 and 24, it is possible to use, appropriately, an ordinary roll. The winding roll 702 is not particularly limited, as long as it is one capable of winding the base material 6 with the gas barrier layer formed, and is appropriately selected from rolls usually used.

The gas supply pipe 41 is sufficient when supply or discharge of a raw material gas and the like at a prescribed speed is possible. As the power source 51 for generating plasma, it is possible to appropriately use a power source of an ordinary plasma-generating apparatus. The power source 51 for generating plasma supplies electric powers to the deposition roll 31 and the deposition roll 32 connected thereto, and makes it possible to utilize these as counter electrodes for discharge. As the power source 51 for generating plasma, since it is possible to perform plasma CVD more effectively, it is preferable to utilize a power source (alternator etc.) that can reverse alternately polarities of a pair of deposition rolls. It is more preferable that the power source 51 for generating plasma can set an applied electric power to 100 W to 10 kW and a frequency of alternate current to 50 Hz to 500 kHz, in order to perform more effectively the plasma CVD. As the magnetic field-generating devices 61 and 62, it is possible to use, appropriately, an ordinary magnetic field-generating device. As the base material 6, it is possible to use, in addition to the base material of the second film, a film having a gas barrier layer previously formed. By using a film having a gas barrier layer previously formed as the base material 6, as described above, it is possible to make the thickness of the gas barrier layer thick.

It is possible to manufacture the second film, by using the manufacturing apparatus shown in Fig. 4 and appropriately adjusting, for example, the kind of a raw material gas, the electric power of a electrode drum of the plasma-generating device, the pressure in the vacuum chamber, the diameter of the deposition roll and conveying velocity of the film.

By using the manufacturing apparatus shown in Fig. 4, and by generating discharge between the pair of deposition rolls (deposition rolls 31 and 32) while supplying a deposition gas (raw material gas etc.) into the vacuum chamber, the deposition gas (raw material gas etc.) is decomposed by plasma, and, on the surface of the base material 6 on the deposition roll 31 and on the surface of the base material 6 on the deposition roll 32, gas barrier layer is formed by a plasma CVD method. In the deposition like this, since the base material 6 is conveyed by each of the feeding roll 701, the deposition roll 31 and the like, the gas barrier layer is formed on the surface of the base material 6, by a continuous deposition process of a roll-to-roll system.

The raw material gas in the deposition gas used for the formation of the gas barrier layer is appropriately selected in accordance with the material quality of the gas barrier layer to be formed. As the raw material gas, it is possible to use, for example, an organosilicon compound containing silicon. The raw material gas may contain, in addition to the organosilicon compound, monosilane being a silicon source.

The raw material gas contains at least one kind of organosilicon compound selected from a group consisting of, for example, hexamethyldisiloxane, 1,1,3,3-tetramethyldisiloxane, vinyltrimethylsilane, methyltrimethylsilane, hexamethyldisilane, methylsilane, dimethylsilane, trimethylsilane, diethylsilane, propylsilane, phenylsilane, vinyltriethoxysilane, vinyltrimethoxysilane, tetramethoxysilane, tetraethoxysilane, phenyltrimethoxysilane, methyltriethoxysilane, and octamethylcyclotetrasiloxane. Among these organosilicon compounds, from the viewpoint of characteristics such as handling property of the compound and gas barrier characteristics of the gas barrier layer to be obtained, hexamethyldisiloxane and 1,1,3,3-tetramethyldisiloxane are preferable. It is possible to use these organosilicon compounds in one kind alone or in a combination of two or more kinds.

The deposition gas may contain, in addition to the raw material gas, a reaction gas. As the reaction gas, it is possible to appropriately select and use a gas reacting with the raw material gas, to form an inorganic compound such as an oxide, a nitride or the like. As the reaction gas for forming an oxide, it is possible to use, for example, oxygen or ozone. As the reaction gas for forming a nitride, it is possible to use, for example, nitrogen or ammonia. These reaction gases are used in one kind alone or in a combination of two or more kinds. For example, in the case of forming an oxynitride, it is possible to combine a reaction gas for forming an oxide and a reaction gas for forming a nitride.

As the deposition gas, in order to supply the raw material gas into the vacuum chamber, a carrier gas may be used as necessary. As the deposition gas, in order to generate plasma discharge, a gas for discharge may be used as necessary. As the carrier gas and the gas for discharge, it is possible to use appropriately known one. It is possible to use, for example, a rare gas such as helium, argon, neon and xenon, or hydrogen as a carrier gas or a gas for discharge.

In the case where the deposition gas contains the raw material gas and the reaction gas, it is preferable that, in the ratio between the raw material gas and the reaction gas, the ratio of the reaction gas is not too excessive compared with the ratio of the reaction gas that becomes necessary theoretically for reacting completely the raw material gas and the reaction gas. By controlling suitably the ratio of the reaction gas, it is possible to form particularly effectively the thin film (gas barrier layer) that meets all the above conditions (i) to (iii). In the case where the deposition gas contains an organosilicon compound and oxygen, it is preferable that the oxygen amount of the deposition gas is the theoretical oxygen amount necessary for oxidizing completely the whole amount of the organosilicon compound in the deposition gas, or less.

Hereinafter, there will described in more detail the preferable ratio between the raw material gas and the reaction gas in the deposition gas, and the like, by taking, as an example, the case of manufacturing a gas barrier layer of a silicon-oxygen system by the use of a gas, as a deposition gas, containing hexamethyldisiloxane (organosilicon compound: HMDSO: $(CH_3)_6Si_2O$:) as a raw material gas and oxygen ($O_2$) as a reaction gas.

In the case of fabricating a gas barrier layer of a silicon-oxygen system by reacting, by plasma CVD, the deposition gas containing hexamethyldisiloxane (HMDSO, $(CH_3)_6Si_2O$) as the raw material gas and oxygen ($O_2$) as the reaction gas, a reaction indicated by the following reaction formula (3) occurs in the deposition gas:

$$(CH_3)_6Si_2O + 1202 \rightarrow 6CO_2 + 9H_2O + 2SiO_2 \qquad (3)$$

and silicon dioxide is formed. In this reaction, the amount of oxygen necessary for oxidizing completely one mole of hexamethyldisiloxane is 12 moles. Accordingly, in the case where 12 moles or more of oxygen relative to 1 mole of hexamethyldisiloxane is contained in the deposition gas to cause them to react with each other completely, a uniform silicon dioxide film can be formed. In this case, there is a high possibility of not being able to form a gas barrier layer meeting all the above conditions (i) to (iii). Accordingly, when forming the gas barrier layer according to the present embodiment, it is preferable to set the amount of oxygen to smaller than 12 moles being the stoichiometric ratio, relative to 1 mole of hexamethyldisiloxane, so that the reaction of the above formula (3) does not proceed completely. In the reaction in an actual plasma CVD chamber, hexamethyldisiloxane being the raw material and oxygen being the reaction gas are supplied to a deposition region from a gas supply part and deposited, and thus, even if the molar amount (flow amount) of oxygen being the reaction gas is a molar amount (flow amount) that is twelve times the molar amount (flow amount) of hexamethyldisiloxane being the raw material, it is considered that, actually, the reaction does not proceed completely and that there are many cases where the reaction finishes only after supplying oxygen much excessively as compared with the stoichiometric ratio. For example, there is also a case where, in order to perform complete oxidation by CVD and to obtain silicon oxide, the molar amount (flow amount) of oxygen is set to not less than approximately 20 times the molar amount (flow amount) of hexamethyldisiloxane being the raw material. Therefore, it is preferable that the the molar amount (flow amount) of oxygen relative to the molar amount (flow amount) of hexamethyldisiloxane being the raw material is an amount of 12 times the amount being the stoichiometric ratio or less (more preferably 10 times or less). By causing the deposition gas to contain hexamethyldisiloxane and oxygen at the ratio, carbon atoms and hydrogen atoms in hexamethyldisiloxane having not completely been oxidized are taken in the gas barrier layer. As the result, it is possible to form the gas barrier layer that meets all the above conditions (i) to (iii). Consequently, it becomes possible to cause the second film to be obtained to exert excellent barrier characteristics and flex resistance. When the molar amount (flow amount) of oxygen relative to the molar amount (flow amount) of hexamethyldisiloxane in the deposition gas is too small, carbon atoms and hydrogen atoms having been not oxidized are excessively taken in the gas barrier layer. In this case, the transparency of the gas barrier layer lowers, and, therefore, it becomes difficult to utilize the gas barrier layer as a flexible substrate for a device that requires transparency such as an organic EL device and an organic thin film solar cell. From this viewpoint, it is preferable that the molar amount (flow amount) of oxygen relative to the molar amount (flow amount) of hexamethyldisiloxane in the deposition gas is an amount greater than 0.1 time the molar amount (flow amount) of hexamethyldisiloxane, and it is more preferable that it is an amount greater than 0.5 times.

It is possible to adjust appropriately the pressure (vacuum degree) in the vacuum chamber in accordance with the kind of the raw material gas and the like, and it is preferable that the pressure is in the range of 0.1 Pa to 50Pa.

In the plasma CVD method like this, in order to discharge between the deposition rolls 31 and 32, the electric power to be applied to an electrode drum (in the embodiment, placed in the deposition rolls 31 and 32) connected to the power source 51 for generating plasma is appropriately adjusted in accordance with the kind of the raw material gas and pressure in the vacuum chamber and the like, and is preferably 0.1 to 10 kW. When the applied electric power is less than the lower limit, particles tend to be easily caused, and when the applied electric power exceeds the upper limit, an amount of heat arising at the time of deposition increases and the temperature of the base material surface in the deposition rises. When the temperature rises too high, there is a possibility that the base material suffers damage by heat and wrinkles arise at the time of deposition. In some cases, there is a risk that the film melts by heat, the deposition roll is exposed, discharge of a large current occurs between deposition rolls and the deposition roll itself suffers damage.

It is possible to adjust appropriately the conveying speed (line speed) of the base material 6 in accordance with the kind of the raw material gas, the pressure in the vacuum chamber and the like, and it is preferable that the speed is 0.1 to 100 m/min, and is more preferable that the speed is 0.5 to 20 m/min. When the line speed is less than the lower limit, wrinkles caused by heat tend to occur easily in the film, and when the line speed exceeds the upper limit, the thickness of the gas barrier layer to be formed tends to become small.

First film

As described above, when the light emitted from an organic EL element exits to the external world through the first film, it is necessary that the first film is formed with a member that exhibits optical transparency. In the case, it is preferable that the first film has, in the same manner as the second film, the second gas barrier layer. The second gas barrier layer according to an embodiment contains silicon atoms, oxygen atoms and carbon atoms, and the distribution curve of silicon, the distribution curve of oxygen and the distribution curve of carbon of the second gas barrier layer meet the above-mentioned conditions (i) to (iii). It is possible to form the second gas barrier layer in the same manner as the gas barrier layer in the above-mentioned second film. The second gas barrier layer may have completely the same configuration as the gas barrier layer of the second film, but as long as the distribution curve of oxygen and the distribution curve of carbon meet the conditions (i) to (iii), the second gas barrier layer may have a configuration different from the gas barrier layer of the second film.

Organic EL element

Next, the configuration of the organic EL element will be described. The organic EL element is formed on the first film or the second film, before the first film and the second film are bonded together.

The organic EL element is constituted by a pair of electrodes composed of an anode and a cathode, and a light-emitting layer provided between the electrodes. Between the pair of electrodes, in addition to the light-emitting layer, a prescribed layer is occasionally provided if necessary. The light-emitting layer is not limited to one layer but is occasionally provided in plural layers.

Layers provided between the cathode and the light-emitting layer include an electron injection layer, an electron transport layer, a hole block layer and the like. When both the electron injection layer and the electron transport layer are provided between the cathode and the light-emitting layer, the layer in contact with the cathode denotes the electron injection layer, and a layer excluding the electron injection layer denotes the electron transport layer.

The electron injection layer has a function of improving the electron injection efficiency from the cathode. The electron transport layer has a function of improving the electron injection from a layer in contact with the surface on the cathode side. The hole block layer has a function of interrupting the transport of holes. In the case where the electron injection layer and/or the electron transport layer have/has a function of interrupting the transport of holes, these layers occasionally serve also as the hole block layer.

It is possible to confirm that the hole block layer has a function of interrupting the transport of holes, for example, by fabricating an element that allows only a hole current to flow and on the basis of the decrease in the current value thereof.

Layers to be provided between the anode and the light-emitting layer include a hole injection layer, a hole transport layer and an electron block layer etc. In the case where both layers of the hole injection layer and the hole transport layer are provided between the anode and the light-emitting layer, the layer in contact with the anode is denoted as the hole injection layer, and the layer excluding the hole injection layer is denoted as the hole transport layer.

The hole injection layer has a function of improving the hole injection efficiency from the anode. The hole transport layer has a function of improving hole injection from the layer in contact with the surface on the anode side. The electron block layer has a function of interrupting the transport of electrons. In the case where the hole injection layer and/or the hole transport layer have/has a function of interrupting the transport of electrons, these layers occasionally serve also as the electron block layer.

It is possible to confirm that the electron block layer has the function of interrupting the transport of electrons, for example, by fabricating an element that allows only an electron current to flow and on the basis of the decrease in a current value thereof.

The electron injection layer and the hole injection layer are sometimes, collectively, denoted as a charge injection layer, and the electron transport layer and the hole transport layer are sometimes, collectively, denoted as a charge transport layer.

An example of a layer configuration the organic EL element of the present embodiment can have will be shown as follows.

a) anode/ light-emitting layer/ cathode
b) anode/ hole injection layer/ light-emitting layer/ cathode
c) anode/ hole injection layer/ light-emitting layer/ electron injection layer/ cathode
d) anode/ hole injection layer/ light-emitting layer/ electron transport layer/ cathode
e) anode/ hole injection layer/ light-emitting layer/ electron transport layer/ electron injection layer/ cathode
f) anode/ hole transport layer/ light-emitting layer/ cathode
g) anode/ hole transport layer/ light-emitting layer/ electron injection layer/ cathode
h) anode/ hole transport layer/ light-emitting layer/ electron transport layer/ cathode
i) anode/ hole transport layer/ light-emitting layer/ electron transport layer/ electron injection layer/ cathode
j) anode/ hole injection layer/ hole transport layer/ light-emitting layer/ cathode
k) anode/ hole injection layer/ hole transport layer/ light-emitting layer/ electron injection layer/ cathode
l) anode/ hole injection layer/ hole transport layer/ light-emitting layer/ electron transport layer/ cathode

m) anode/ hole injection layer/ hole transport layer/ light-emitting layer/ electron transport layer/ electron injection layer/ cathode

n) anode/ light-emitting layer/ electron injection layer/ cathode

o) anode/ light-emitting layer/ electron transport layer/ cathode

p) anode/ light-emitting layer/ electron transport layer/ electron injection layer/ cathode

Here, the sign "/" denotes that two layers described with "/" inserted therebetween are stacked adjacently. Hereinafter, the same as above.

The organic EL element of the present embodiment may have two or more light-emitting layers. In any one of the above layer configurations of a) to p), when denoting the stacked body sandwiched between the anode and the cathode as "a structural unit A," the configuration of an organic EL element having two light-emitting layers includes a layer configuration shown in the following q). Layer configurations existing in two (construction units A) may be the same or different from each other.

q) anode/ (construction unit A)/ charge generation layer/ (construction unit A)/ cathode

When denoting "(construction unit A)/ charge generation layer" as "a construction unit B," the configuration of an organic EL element having a light-emitting layer of three or more layers includes a layer configuration shown in the following r).

# r) anode/ (construction unit B)x/ (construction unit A)/ cathode

The sign "x" shows an integer of 2 or more, and (construction unit B) x shows a stacked body composed of construction units B stacked in x stages. Layer configurations of a plurality of (construction units B) may be the same or different.

The charge generation layer is a layer that generates holes and electrons by applying an electric field. Examples of the charge generation layer include thin films containing vanadium oxide, indium tin oxide (abbreviated name: ITO), molybdenum and the like.

It is possible to set appropriately the order, the number and the thickness of each of layers of layers to be stacked in consideration of the luminous efficiency and element life time.

Next, materials and formation methods of each of layers constituting the organic EL element will be described more specifically.

Anode

In the case of an organic EL element having a configuration in which light radiated from the light-emitting layer is emitted out through the anode, an electrode exhibiting optical transparency is used as the anode. As the electrode exhibiting optical transparency, it is possible to use a thin film of a metal oxide, a metal sulfide, a metal and the like, and an electrode having a high electroconductivity and light transmittance is preferable. Specifically, a thin film containing indium oxide, zinc oxide, tin oxide, ITO, indium zinc oxide (abbreviated expression: IZO), gold, platinum, silver, copper and the like is used. Among them, a thin film composed of ITO, IZO or tin oxide is preferable. Methods for fabricating the anode include a vacuum evaporation method, a sputtering method, an ion plating method, a plating method and the like. As the anode, the use of an organic transparent electroconductive film such as polyaniline or derivatives thereof, and polythiophene or derivatives thereof is also possible.

The thickness of the anode is appropriately set in consideration of characteristics to be required and ease of the process, and is, for example, 10 nm to 10 $\mu$m, preferably 20 nm to 1 $\mu$m, further more preferably 50 nm to 500 nm.

Hole injection layer

Hole injection materials constituting the hole injection layer include oxides such as vanadium oxide, molybdenum oxide, ruthenium oxide and aluminum oxide; phenylamine-based compounds; starburst type amine-based compounds; phthalocyanine-based compounds; amorphous carbon; polyaniline; thiophene derivatives and the like.

Examples of the methods for depositing the hole injection layer include deposition from a solution containing a hole injection material. For example, it is possible to form the hole injection layer by coating a solution containing a hole injection material by a prescribed coating method to perform deposition, and solidifying the solution used for deposition.

Solvents to be used for the deposition from a solution are not particularly limited as long as they dissolve the hole injection material, and include chlorine-based solvents such as chloroform, methylene chloride and dichloroethane; ether-based solvents such as tetrahydrofuran; aromatic hydrocarbon-based solvents such as toluene and xylene; ketone-based solvents such as acetone and methyl ethyl ketone; ester-based solvents such as ethyl acetate, butyl acetate and ethyl cellosolve acetate; and water.

Coating methods include a spin coat method, a casting method, a micro gravure coat method, a gravure coat method, a bar coat method, a roll coat method, a wire bar coat method, a dip coat method, a spray coat method, a screen printing method, a flexographic printing method, an offset printing method, an ink jet printing method and the like.

The thickness of the hole injection layer is appropriately set in consideration of characteristics to be required and ease of the process, and is, for example, 1 nm to 1 $\mu$m, preferably 2 nm to 500 nm, further more preferably 5 nm to 200 nm.

Hole transport layer

Hole transport materials constituting the hole transport layer include polyvinyl carbazole or derivatives thereof, polysilane or derivatives thereof, polysiloxane derivatives having an aromatic amine on a side chain or main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrole or derivatives thereof, poly(p-phenylene vinylene) or derivatives thereof, poly(2,5-thienylene vinylene) or derivatives thereof and the like.

Among them, as the hole transport material, polymer hole transport materials such as polyvinyl carbazole or derivatives thereof, polysilane or derivatives thereof, polysiloxane derivatives having an aromatic amine compound group on the side chain or main chain, polyaniline or derivatives thereof, polythiophene or derivatives thereof, polyarylamine or derivatives thereof, poly(p-phenylene vinylene) or derivatives thereof, poly(2,5-thienylene vinylene) or derivatives thereof and the like are preferable. Further preferable hole transport materials are polyvinyl carbazole or derivatives thereof, polysilane or derivatives thereof, and polysiloxane derivatives having an aromatic amine on a side chain or main chain. A low-molecular hole transport material is preferably used after dispersing it in a polymer binder.

Methods for depositing the hole transport layer are not particularly limited, and include, for a low-molecular hole transport material, deposition from a mixed liquid containing a polymer binder and a hole transport material, and include, for a high-molecular hole transport material, deposition from a solution containing a hole transport material.

Solvents to be used for the deposition from a solution are not particularly limited as long as they dissolve the hole transport material, and include chlorine-based solvents such as chloroform, methylene chloride and dichloroethane; ether-based solvents such as tetrahydrofuran; aromatic hydrocarbon-based solvents such as toluene and xylene; ketone-based solvents such as acetone and methyl ethyl ketone; ester-based solvents such as ethyl acetate, butyl acetate and ethyl cellosolve acetate and the like.

Deposition methods from a solvent include coating methods the same as aforementioned deposition methods of the hole injection layer.

It is preferable that a polymer binder combined with the hole transport material does not extremely inhibit the electron transport, and it is preferable that the absorption for visible light is weak. The polymer binder is selected from, for example, polycarbonate, polyacrylate, polymethylacrylate, polymethylmethacrylate, polystyrene, polyvinyl chloride and polysiloxane.

The thickness of the hole transport layer differs in the optimal value depending on a material to be used, and is set appropriately so that a drive voltage and luminous efficiency become reasonable values. It is necessary that the hole transport film has a thickness at which a pinhole does not occur, and too much thickness leads to a high drive voltage of the element. Accordingly, the thickness of the hole transport layer is, for example, 1 nm to 1 $\mu$m, preferably 2 nm to 500 nm, further more preferably 5 nm to 200 nm.

Light-emitting layer

The light-emitting layer is formed, usually, mainly from an organic matter (light-emitting material) that emits fluorescence and/or phosphorescence, or from the organic matter and a dopant that assists this. The dopant is added, for example, for improving the luminous efficiency, or for changing the luminous wavelength. The organic matter contained in the light-emitting layer may be a low-molecular compound or a high-molecular compound. Generally, a high-molecular compound with a high solubility in a solvent rather than a low molecule is used favorably in a coating method, and thus it is preferable that the light-emitting layer contains a high-molecular compound. It is preferable that the light-emitting layer contains a high-molecular compound with a number-average molecular weight of $10^3$ to $10^8$ in terms of polystyrene. Examples of the light-emitting material constituting the light-emitting layer include the following dye-based material, a metal complex-based material, a polymer-based material, and a dopant material.

Dye-based material

Examples of the dye-based material include cyclopentamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimer, pyrazoline dimer, quinacridone derivatives, and coumarin derivatives.

Metal complex-based material

Examples of the metal complex-based material include metal complexes having a central metal selected from rare earth metals such as Tb, Eu and Dy, and Al, Zn, Be, Ir, Pt and the like, and a ligand selected from oxadiazole, thiadiazole, phenylpyridine, phenylbenzimidazole, a quinolone structure and the like. The metal complex-based material is selected from, for example, metal complexes having light-emission from a triplet excitation state such as an iridium complex and a platinum complex, an aluminum quinolinol complex, a benzoquinolinol beryllium complex, a benzoxazolyl zinc complex, a benzothiazole zinc complex, an azomethyl zinc complex, a porphyrin zinc complex, and a phenanthroline europium complex.

Polymer-based materials

Polymer-based materials include poly(p-phenylenevinylene) derivatives, polythiophene derivatives, poly(p-phenylene) derivatives, polysilane derivatives, polyacetylene derivatives, polyfluorene derivatives, polyvinyl carbazole derivatives, and materials in which the above dye-based material or metal complex-based light-emitting material have been made into a polymer, and the like.
Among the above light-emitting materials, materials emitting light in blue include distyrylarylene derivatives, oxadiazole derivatives and polymerized substances thereof, polyvinyl carbazole derivatives, poly(p-phenylene) derivatives, polyfluorene derivatives and the like. Among them, polyvinyl carbazole derivatives, poly(p-phenylene) derivatives, polyfluorene derivatives and the like being polymer materials are preferable.
Materials emitting light in green include quinacridone derivatives, coumarin derivatives and polymerized substances thereof, poly(p-phenylenevinylene) derivatives, polyfluorene derivatives and the like. Among them, poly(p-phenylenevinylene) derivatives, polyfluorene derivatives and the like being polymer materials are preferable.
Materials emitting light in red include coumarin derivatives, thiophene ring compounds and polymerized substances thereof, poly(p-phenylenevinylene) derivatives, polythiophene derivatives, polyfluorene derivatives and the like. Among them, polymer poly(p-phenylenevinylene) derivatives, polythiophene derivatives, polyfluorene derivatives and the like being polymer materials are preferable.
Materials emitting light in white may be a mixture of the above materials emitting light in each color of blue, green or red, or may be a polymer material formed by mixing components (monomers) forming materials emitting light in respective colors and by polymerizing these. By stacking plural light-emitting layers formed by using each of materials emitting light in the respective colors, an element emitting light in white as a whole may be configured.

Dopant materials

Examples of the dopant materials include perylene derivatives, coumarin derivatives, rubrene derivatives, quinacridone derivatives, squarium derivatives, porphyrin derivatives, a styryl-based dye, tetracene derivatives, pyrazolone derivatives, decacyclene and phenoxazone. The thickness of the light-emitting layer is usually about 2 nm to 200 nm.

Method for depositing light-emitting layer

As a method for depositing the light-emitting layer, it is possible to use a method of coating a solution containing a light-emitting material, a vacuum evaporation method, a transfer method and the like. Solvents for use in the deposition from a solution include the same solvent as the aforementioned solvent to be used in depositing the hole injection layer from a solution.
Methods for coating a solution containing a light-emitting material include coating methods such as a spin coat method, a casting method, a micro gravure coat method, a gravure coat method, a bar coat method, a roll coat method, a wire bar coat method, a dip coat method, a slit coat method, a capillary coat method, a spray coat method and a nozzle coat method, and printing methods such as a gravure printing method, a screen printing method, a flexographic printing method, an offset printing method, an inverse printing method and an ink jet printing method. From the viewpoint that pattern formation and multicolor toning are easy, printing methods such as a gravure printing method, a screen printing method, a flexographic printing method, an offset printing method, an inverse printing method, an ink jet printing method and the like are preferable. In the case of a low-molecular compound exhibiting sublimation property, it is possible to use a vacuum evaporation method. It is also possible to use a method of forming a light-emitting layer only in a desired part, by transfer by laser or thermal transfer.

Electron transport layer

As an electron transport material constituting the electron transport layer, it is possible to use materials usually used, and the materials include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyano ethylene or derivatives thereof, diphenoquinone derivatives, or metal complexes of 8-hydroxyquinoline or derivatives thereof, polyquinoline or derivatives thereof, polyquinoxaline or derivatives thereof, polyfluorene or derivatives thereof and the like.

Among these, as the electron transport material, oxadiazole derivatives, benzoquinone or derivatives thereof, anthraquinone or derivatives thereof or metal complexes of 8-hydroxyquinoline or derivatives thereof, polyquinoline or derivatives thereof, polyquinoxaline or derivatives thereof and polyfluorene or derivatives thereof are preferable, and 2-(4-biphenylyl)-5-(4-t-butylphenyl)-1,3,4-oxadiazole, benzoquinone, anthraquinone, tris(8-quinolinol)aluminum, and polyquinoline are further preferable.

A method of depositing an electron transport layer is not particularly limited. In the case of a low-molecular electron transfer material, the method includes a vacuum evaporation method from powder, or deposition from a solution or a molten state, and, in the case of a polymer electron transport material, the method includes deposition from a solution or a molten state. In the case of deposition from a solution or a molten state, a polymer binder may be used together. Methods for depositing the electron transport layer from a solution include the same deposition method as the above-mentioned method for depositing the hole injection layer from a solution.

The thickness of the electron transport layer is different in the optimal value depending on a material to be used, and is set appropriately so that a drive voltage and luminous efficiency become reasonable values. It is necessary that the electron transport layer has at least a thickness at which a pinhole does not occur, and having too much thickness leads to a high drive voltage of the element. Therefore, the thickness of the electron transport layer is, for example, 1 nm to 1 $\mu$m, preferably 2 nm to 500 nm, and further preferably 5 nm to 200 nm.

Electron injection layer

As a material constituting the electron injection layer, the optimal material is appropriately selected in accordance with the kind of the light-emitting layer. Materials constituting the electron injection layer include an alkali metal; an alkali earth metal; an alloy containing one or more kinds of metals selected from an alkali metal and an alkali earth metal; an oxide, a halide, and a carbonate of an alkali metal or an alkali earth metal; mixtures of these materials, and the like. Examples of the alkali metal; and the oxide, halide and carbonate of the alkali metal include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, lithium carbonate, and the like. Examples of the alkali earth metal; and the oxide, halide and carbonate of the alkali earth metal include magnesium, calcium, barium, strontium, magnesium oxide, magnesium fluoride, calcium oxide, calcium fluoride, barium oxide, barium fluoride, strontium oxide, strontium fluoride, magnesium carbonate, and the like. The electron injection layer may be constituted by a stacked body in which two or more layers are stacked. Examples of the stacked bodies of the electron injection layer include LiF/Ca. The electron injection layer is formed by an evaporation method, a sputtering method, a printing method, or the like. The thickness of the electron injection layer is preferably approximately 1 nm to 1 $\mu$m.

Cathode

As the material of the cathode, a material with a small work function, capable of electron injection easily into the light-emitting layer, and with a high electroconductivity is preferable. In the case of an organic EL element having a configuration taking out light from the anode side, in order to reflect light radiated from the light-emitting layer toward the anode side at the cathode, a material with a high visible light reflectance is preferable as the material of the cathode. As the material of the cathode, it is possible to use, for example, alkali metals, alkali earth metals, transition metals, and XIII group metals in the periodic table. As the material of the cathode, there can be used, for example, metals such as lithium, sodium, potassium, rubidium, cesium, beryllium, magnesium, calcium, strontium, barium, aluminum, scandium, vanadium, zinc, yttrium, indium, cerium, samarium, europium, terbium, ytterbium and an alloy containing two or more kinds of metals selected from these, an alloy of one or more kinds selected from the metals and one kind or more kinds selected from gold, silver, platinum, copper, manganese, titanium, cobalt, nickel, tungsten and tin, or graphite or graphite intercalation compound. Examples of the alloys include magnesium-silver alloy, magnesium-indium alloy, magnesium-aluminum alloy, indium-silver alloy, lithium-aluminum alloy, lithium-magnesium alloy, lithium-indium alloy, calcium-aluminum alloy and the like. As the cathode, a transparent electroconductive electrode composed of an electroconductive metal oxide, an electroconductive organic matter and the like can be used. Specifically, electroconductive metal oxides include indium oxide, zinc oxide, tin oxide, ITO and IZO, and electroconductive organic matters include polyaniline or derivatives thereof, polythiophene or derivatives thereof, and the like. The cathode may be constituted by a stacked body in which two or more layers are stacked. There is also a case where the electron injection layer is used as the cathode.

The thickness of the cathode is appropriately designed in consideration of required characteristics and ease of processes etc., and is, for example, 10 nm to 10 $\mu$m, preferably 20 nm to 1 $\mu$m, and further preferably 50 nm to 500 nm.

Methods for manufacturing the cathode include a vacuum evaporation method, a sputtering method, a laminate method in which thermocompression of a metal thin film is performed, and the like.

The above organic EL device can be used as an illuminating device, a surface light source device or a display device, by adding a prescribed constituent component.

**EXAMPLES**

Reference example A1

By the use of the manufacturing apparatus shown in the aforementioned Fig. 4, the second film was manufactured. That is, by the use of a biaxially stretched polyethylenenaphthalate film (PEN film, thickness: 100 $\mu$m, width: 350 mm, manufactured by Teijin DuPont Films Limited, trade name "Teonex Q65FA") as a base material (base material 6), this was mounted on the feeding roll 701. Then, by the application of a magnetic field between the deposition roll 31 and the deposition roll 32, and by the supply of electric power to each of the deposition roll 31 and the deposition roll 32, discharge was performed and plasma was generated, between the deposition roll 31 and the deposition roll 32. To the formed discharge region, a deposition gas (a mixed gas of hexamethyldisiloxane (HMDSO) was supplied as a raw material gas and oxygen gas as a reaction gas (which functions also as a discharge gas)), thin film formation by a plasma CVD method was performed under the following conditions, and the second film having the gas barrier layer was obtained.

Deposition conditions

Supplied amount of the raw material gas: 50 sccm (0 degree, Standard Cubic Centimeter per Minute in terms of 1 atm. Hereinafter, the same as above.)
Supplied amount of the oxygen gas: 500 sccm Vacuum degree in the vacuum chamber: 3 Pa
Applied power from a power source for generating plasma: 0.8 kW
Frequency of the power source for generating plasma: 70 kHz
Conveying speed of a film: 0.5 m/min

The thickness of the gas barrier layer in the obtained second film was 0.3 $\mu$m. Furthermore, the vapor transmittance of the obtained second film was $3.1 \times 10^{-4}$ g/(m$^2$.day) under conditions of temperature 40°C, humidity on the lower humidity side 0% RH and humidity on the higher humidity side 90% RH, and was a value of detection limit or lower under conditions of temperature 40°C, humidity on the lower humidity side 10% RH and humidity on the higher humidity side 100% RH. Moreover, the vapor transmittance of the second film under conditions of temperature 40°C, humidity on the lower humidity side 10% RH and humidity on the higher humidity side 100% RH, after bending the second film under a condition of the curvature radius 8 mm, was a value of the detection limit or lower, and it was confirmed that, even in the case of bending the second film, the lowering of the gas barrier characteristics is suppressed sufficiently.

As to the obtained second film, XPS depth profile measurement was performed under the following conditions, and the distribution curve of silicon, the distribution curve of oxygen, the distribution curve of carbon and the distribution curve of oxygen-carbon were obtained.
Etching ion species: argon (Ar$^+$)
Etching rate (value in terms of thermally oxidized SiO$_2$ film): 0.05 nm/sec
Etching spaces (in terms of SiO$_2$): 10 nm
X-ray photoelectron spectrometer: manufactured by Thermo Fisher Scientific K.K., model name "VG Theta Probe"
Irradiated X-rays: single crystal dispersed AlK$\alpha$
Spot of X-rays and size thereof: ellipse of 800 $\times$ 400 $\mu$m

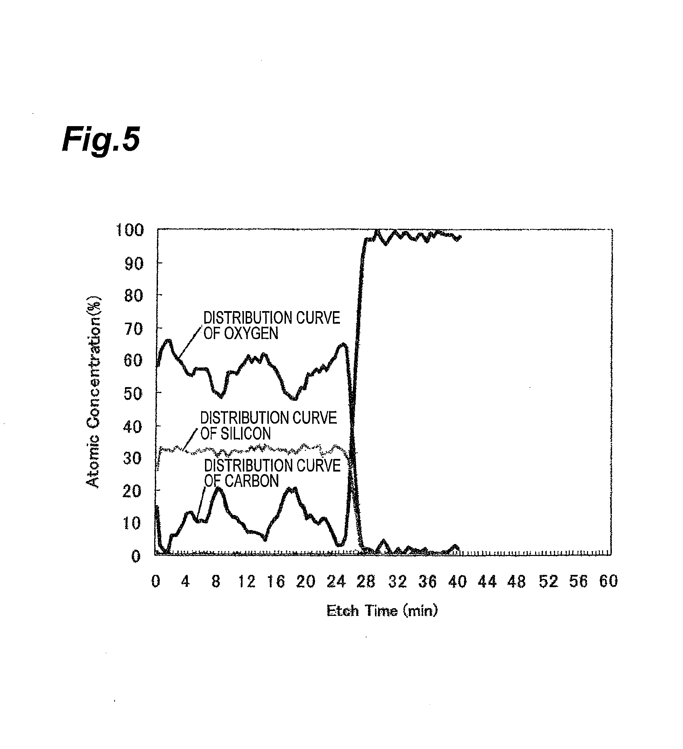

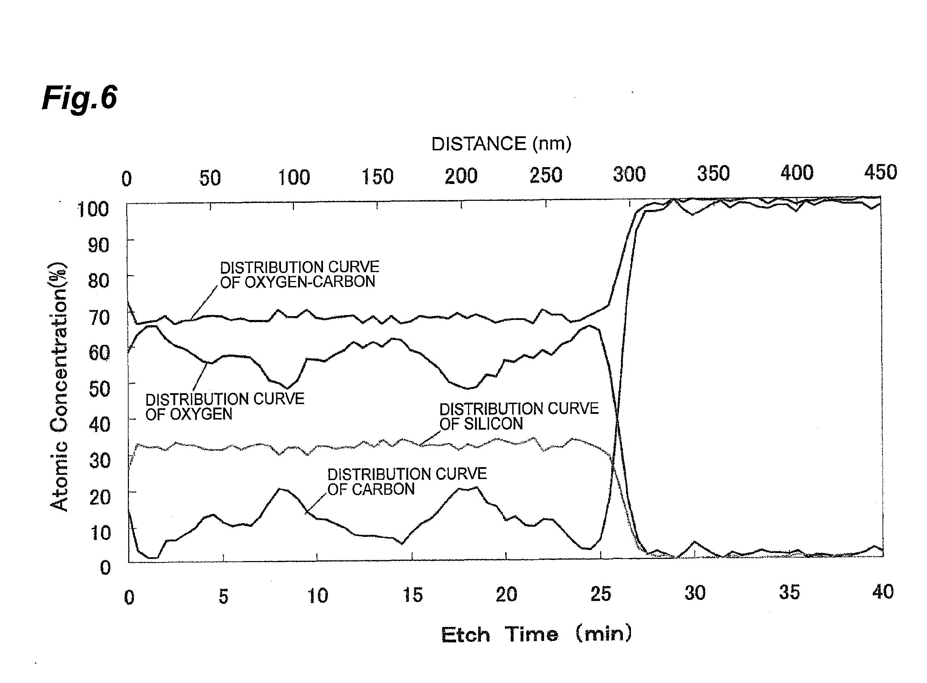

Each of the obtained distribution curve of silicon, distribution curve of oxygen and distribution curve of carbon is shown in Fig. 5. Regarding the obtained distribution curve of silicon, distribution curve of oxygen, distribution curve of carbon and distribution curve of oxygen-carbon, together with the relationship between the atomic ratio (atomic concentration) and etching time, there is shown, on the graph in Fig. 6, the relationship between the atomic ratio (atomic concentration) and the distance (nm) from the surface of the gas barrier layer. The "distance (nm)" described on the abscissa of the graph in Fig. 6 is a value obtained by performing calculation from the etching time and etching speed.

As is clear from results that we show in Fig. 5 and Fig. 6, it was confirmed that the obtained distribution curve of carbon has plural distinct extrema, that the difference between the maximum value and the minimum value of the atomic ratio of carbon is 5 at% or more, and that, in 90% or more of regions in the thickness direction of the gas barrier layer, the atomic ratio of silicon, the atomic ratio of oxygen and the atomic ratio of carbon meet the condition shown by the above-mentioned formula (1).

Reference example A2

The second film having the gas barrier layer of thickness 0.3 $\mu$m obtained in the reference example A1 was mounted on the feeding roll 701 as the base material 6, and a gas barrier layer on the surface of the gas barrier layer was newly formed. Except for this, in the same manner as in the reference example A1, a second film (A) was obtained. The thickness of the gas barrier layer on the base material (PEN film) in the obtained second film (A) was 0.6 $\mu$m.

The obtained second film (A) was mounted on the feeding roll 701 as the base material 6, and a gas barrier layer on the surface of the gas barrier layer was newly formed. Except for this, in the same manner as that in the reference example A1, a second film (B) was obtained.

The thickness of the gas barrier layer in the obtained second film (B) was 0.9 $\mu$m. The vapor transmittance of the obtained second film (B) was $6.9 \times 10^{-4}$ g/(m$^2$.day) under conditions of temperature 40°C, humidity on the lower humidity side 0% RH and humidity on the higher humidity side 90% RH, and was a value of detection limit or lower under conditions of temperature 40°C, humidity on the lower humidity side 10% RH and humidity on the higher humidity side 100% RH. Furthermore, the vapor transmittance of the second film (B) under conditions of temperature 40°C, humidity on the lower humidity side 10% RH and humidity on the higher humidity side 100% RH, after bending the second film (B) under a condition of the curvature radius 8 mm, was a value of the detection limit or lower, and it was confirmed that, even in the case of bending the second film (B), the lowering of the gas barrier characteristics is suppressed sufficiently.

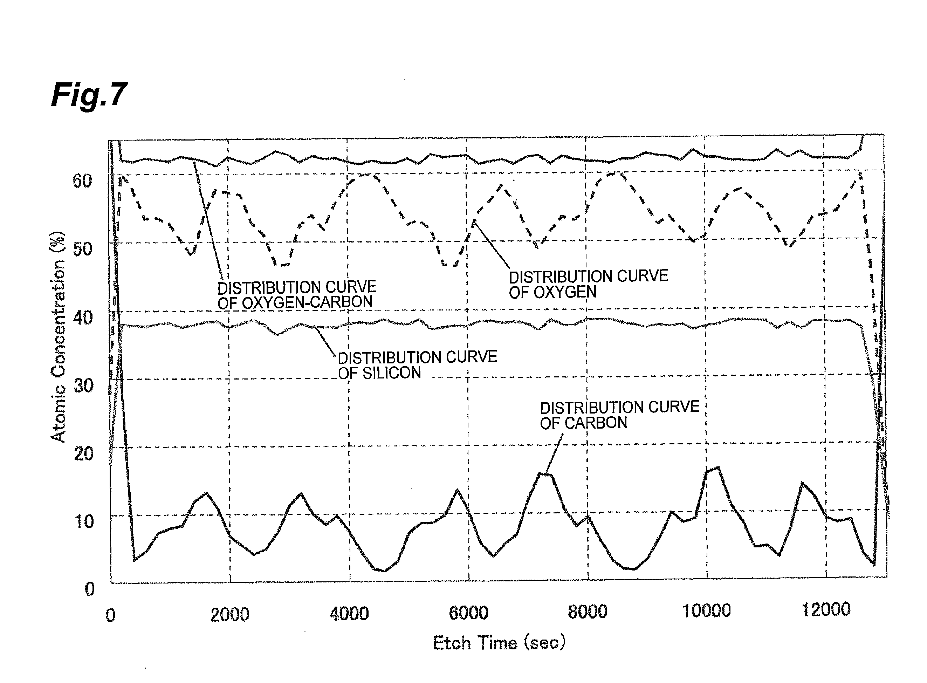

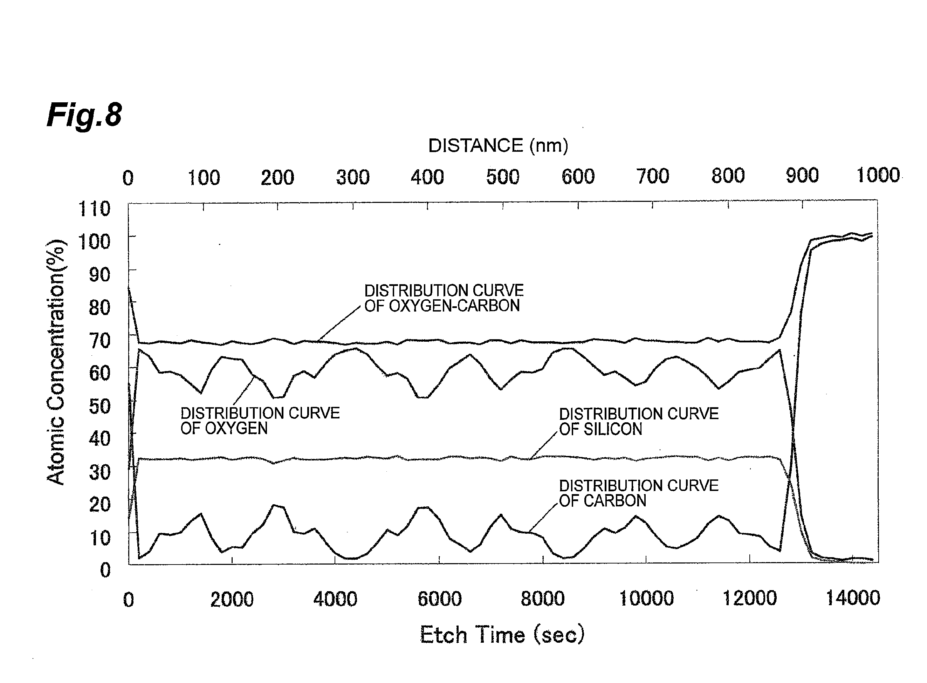

As to the obtained second film (B), the distribution curve of silicon, the distribution curve of oxygen, the distribution curve of carbon and the distribution curve of oxygen-carbon were created by the same method as the method in the reference example A1. The obtained results are shown in Fig. 7. Regarding the obtained distribution curve of silicon, distribution curve of oxygen, distribution curve of carbon and distribution curve of oxygen-carbon, together with the relationship between the atomic ratio (atomic concentration) and etching time, there is shown, on the graph in Fig. 8, the relationship between the atomic ratio (atomic concentration) and the distance (nm) from the surface of the gas barrier layer. The "distance (nm)" described on the abscissa of the graph in Fig. 8 is a value obtained by performing calculation from the etching time and etching speed.

As is clear from results shown in Fig. 7 and Fig. 8, it was confirmed that the obtained distribution curve of carbon has plural distinct extrema, that the difference between the maximum value and the minimum value of the atomic ratio of carbon is 5 at% or more, and that, in 90% or more of regions in the thickness direction of the gas barrier layer, the atomic ratio of silicon, the atomic ratio of oxygen and the atomic ratio of carbon meet the condition shown by the above-mentioned formula (1).

Reference example A3

In the same manner as that in the reference example A1 except for setting the supplied amount of the raw material gas to be 100 sccm, the second film was obtained.

The thickness of the gas barrier layer in the obtained second film was 0.6 $\mu$m. The vapor transmittance of the obtained second film was $3.2 \times 10^{-4}$ g/(m$^2$.day) under conditions of temperature 40°C, humidity on the lower humidity side 0% RH and humidity on the higher humidity side 90% RH, and was a value of detection limit or lower under conditions of temperature 40°C, humidity on the lower humidity side 10% RH and humidity on the higher humidity side 100% RH. Furthermore, the vapor transmittance of the second film under conditions of temperature 40°C, humidity on the lower humidity side 10% RH and humidity on the higher humidity side 100% RH, after bending the second film under a condition of the curvature radius 8 mm, was a value of the detection limit or lower, and it was confirmed that, even in the case of bending the second film, the lowering of the gas barrier characteristics is suppressed sufficiently.

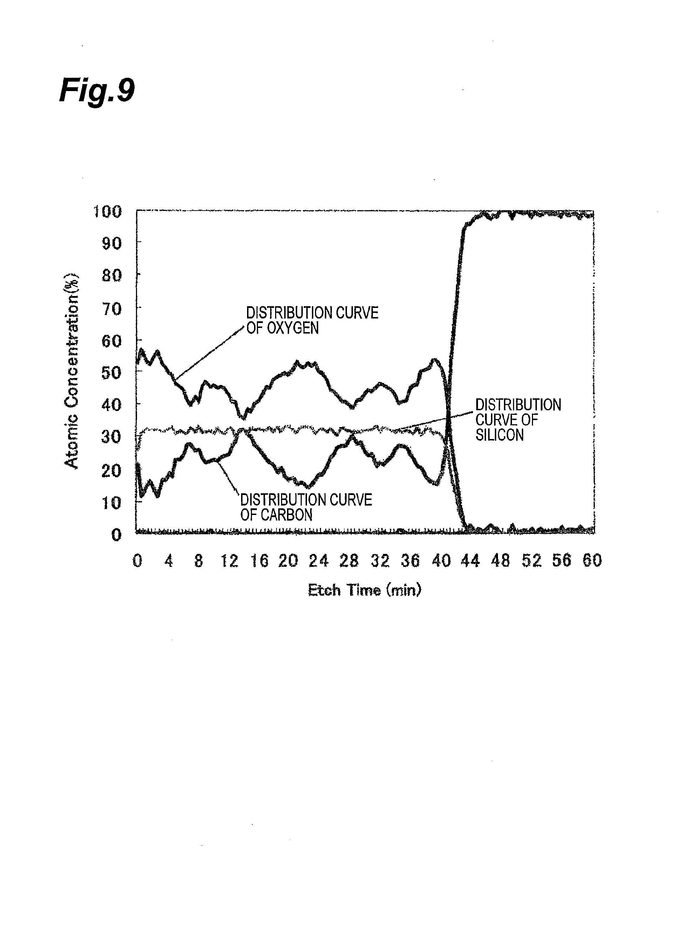

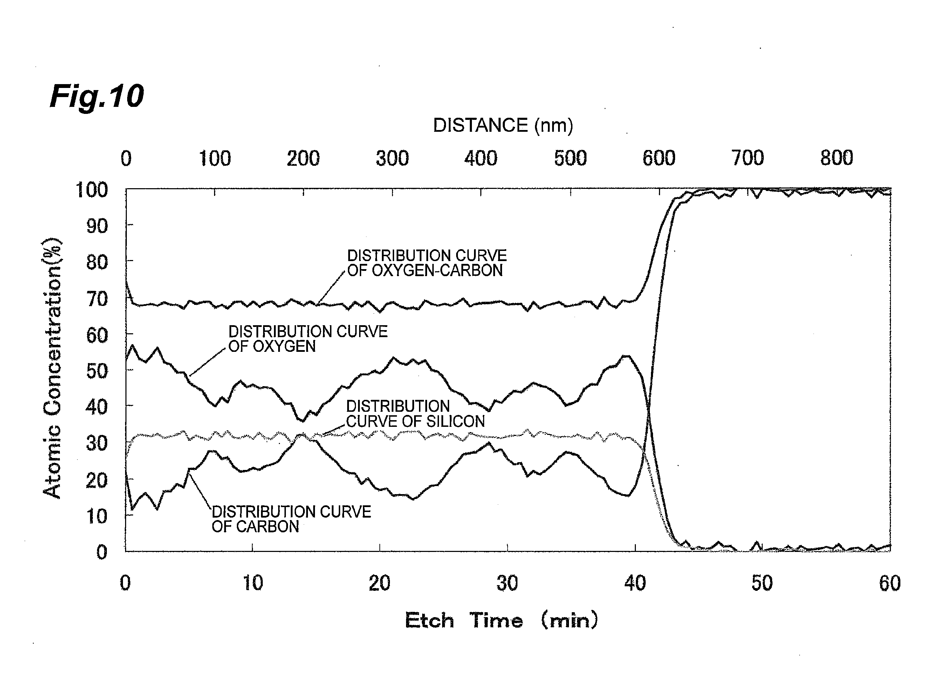

As to the obtained second film, the distribution curve of silicon, the distribution curve of oxygen, the distribution curve of carbon and the distribution curve of oxygen-carbon were created in the same method as the method in the reference example A1. The obtained distribution curve of silicon, distribution curve of oxygen and distribution curve of carbon are shown in Fig. 9. Regarding the obtained distribution curve of silicon, distribution curve of oxygen, distribution curve of carbon and distribution curve of oxygen-carbon, together with the relationship between the atomic ratio (atomic concentration) and etching time, there is shown, on the graph in Fig. 10, the relationship between the atomic ratio (atomic concentration) and the distance (nm) from the surface of the gas barrier layer. The "distance (nm)" described on the abscissa of the graph in Fig. 10 is a value obtained by performing calculation from the etching time and etching speed.

As is clear from results shown in Fig. 9 and Fig. 10, it was confirmed that the obtained distribution curve of carbon has plural distinct extrema, that the difference between the maximum value and the minimum value of the atomic ratio of carbon is 5 at% or more, and that, in 90% or more of regions in the thickness direction of the gas barrier layer, the atomic ratio of silicon, the atomic ratio of oxygen and the atomic ratio of carbon meet the condition shown by the above-mentioned formula (1).

Reference comparative example A1

On the surface of a biaxially stretched polyethylenenaphthalate film (PEN film, thickness: 100 $\mu$m, width: 350 mm, manufactured by Teijin DuPont Films Limited, trade name "Teonex Q65FA"), a gas barrier layer composed of silicon oxide was formed by the use of a silicon target and by a reactive sputtering method in an oxygen containing-gas atmosphere, and a second film for comparison was obtained.

The thickness of the gas barrier layer in the obtained second film was 100 nm. The vapor transmittance of the obtained second film was 1.3 g/($m^2$.day) under conditions of temperature 40°C, humidity on the lower humidity side 10% RH and humidity on the higher humidity side 100% RH, and the gas barrier characteristics thereof were insufficient.

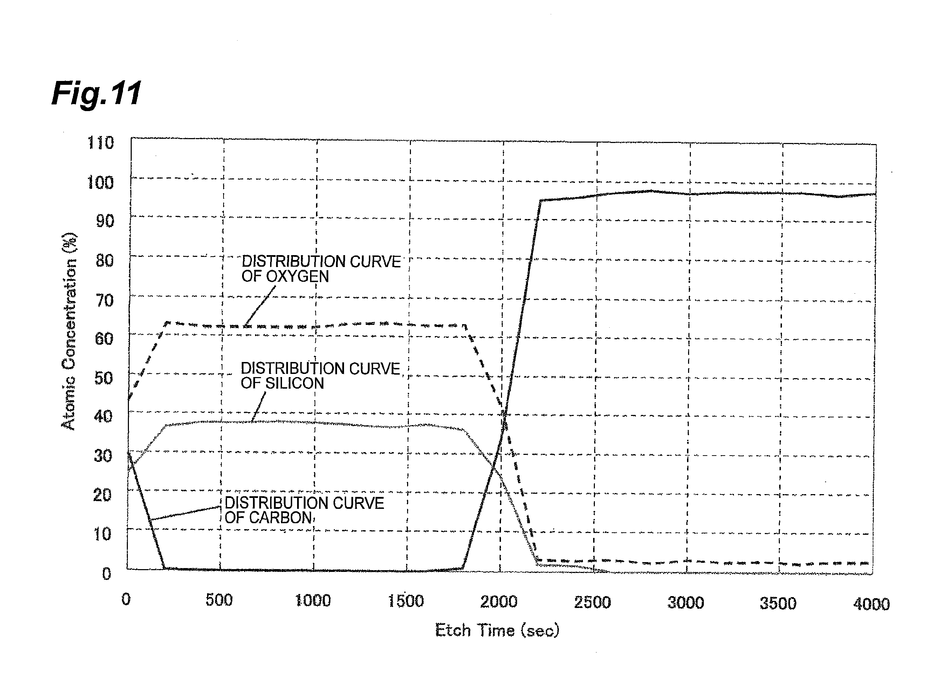

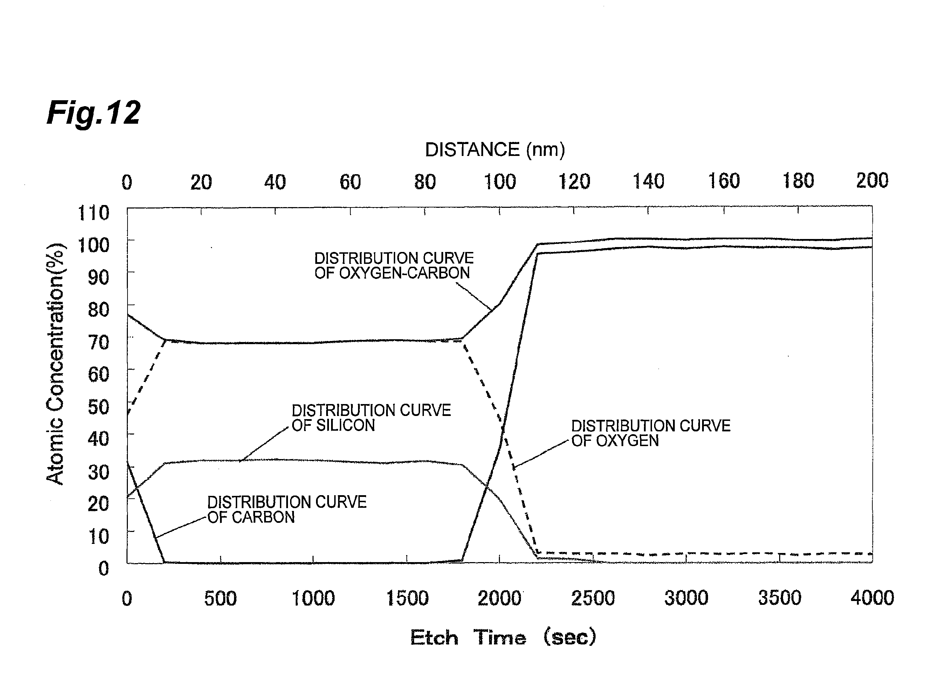

As to the obtained second film, the distribution curve of silicon, the distribution curve of oxygen, the distribution curve of carbon and the distribution curve of oxygen-carbon were created by the same method as the method in the reference example A1. The obtained distribution curve of silicon, distribution curve of oxygen, distribution curve of carbon and distribution curve of oxygen-carbon are shown in Fig. 11. Regarding the obtained distribution curve of silicon, distribution curve of oxygen, distribution curve of carbon and distribution curve of oxygen-carbon, together with the relationship between the atomic ratio (atomic concentration) and etching time, there is shown, on the graph in Fig. 12, the relationship between the atomic ratio (atomic concentration) and the distance (nm) from the surface of the gas barrier layer. The "distance (nm)" described on the abscissa of the graph in Fig. 12 is a value obtained by performing calculation from the etching time and etching speed. As is clear from results shown in Fig. 11 and Fig. 12, it was confirmed that the obtained distribution curve of carbon does not have an extremum.

Industrial Applicability

As described above, the film utilized in the organic EL element according to the present invention has sufficient gas barrier characteristics, and, in addition, even in the case of being subjected to bending, can suppress sufficiently the lowering of gas barrier characteristics.

**Reference Signs List**

| 1 | first film |
|---|---|
| 2 | organic EL element |
| 3 | protective film |
| 4 | adhesion layer |
| 5 | gas barrier layer |
| 6 | base material of second film |
| 7 | base material of first film |
| 8 | second gas barrier layer |
| 11 | second film |
| 13 | organic EL device |
| 500, 510, 520 | unwinding roll |
| 511, 512 | first bonding roll |

| 521, 522 | second bonding roll |
| 513, 523 | conveying roll |
| 530 | winding roll |
| 820 | additional film |
| 610, 620 | coating apparatus |
| 611, 621 | curing apparatus |
| 701 | feeding roll |
| 21,22,23,24 | conveying roll |
| 31,32 | pair of deposition rolls |
| 41 | gas supply pipe |
| 51 | power source for generating plasma |
| 61,62 | magnetic field-generating device |
| 702 | winding roll |

**Claims**

1. An organic EL device comprising:

   a first film;
   a second film disposed facing the first film; and
   an organic EL element interposed between the first film and the second film, wherein
   the second film seals the organic EL element in conjunction with the first film,
   the second film includes a gas barrier layer containing silicon atoms, oxygen atoms and carbon atoms,
   a distribution curve of silicon, a distribution curve of oxygen and a distribution curve of carbon each showing relationship between the ratio of the number of the silicon atoms, the ratio of the number of the oxygen atoms and the ratio of the number of the carbon atoms relative to the total amount of the silicon atoms, oxygen atoms and carbon atoms, and the distance from one surface of the gas barrier layer in the thickness direction of the gas barrier layer, meet the following conditions:

   (i) in 90% or more of the region of the gas barrier layer in the thickness direction, the ratio of the number of the silicon atoms being the second largest value among the ratio of the number of the silicon atoms, the ratio of the number of the oxygen atoms and the ratio of the number of the carbon atoms,
   (ii) the distribution curve of carbon having at least one extremum, and
   (iii) the difference between the maximum value and the minimum value of the ratio of the number of the carbon atoms in the distribution curve of carbon being 5 atom% or more.

2. The organic EL device according to claim, wherein the first film is a metallic film.

3. The organic EL device according to claim 1 or 2, wherein
   the first film includes a second gas barrier layer containing silicon atoms, oxygen atoms and carbon atoms, and
   the distribution curve of silicon, the distribution curve of oxygen and the distribution curve of carbon of the second gas barrier layer meet the conditions (i), (ii) and (iii).

4. An illuminating device having the organic EL device according to any one of claims 1 to 3.

**5.** A surface light source device having the organic EL device according to any one of claims 1 to 3.

**6.** A display device having the organic EL device according to any one of claims 1 to 3.

# Fig.1

*Fig.2*

EP 2 627 151 A1

# *Fig.3*

# Fig.4

**Fig.5**

*Fig.6*

EP 2 627 151 A1

## Fig.7

## Fig.8

EP 2 627 151 A1

## Fig.9

## Fig.10

## Fig.11

Fig.12

## INTERNATIONAL SEARCH REPORT

| International application No. |
|---|
| PCT/JP2011/072885 |

A.   CLASSIFICATION OF SUBJECT MATTER
*H05B33/04*(2006.01)i, *G09F9/30*(2006.01)i, *H01L27/32*(2006.01)i, *H01L51/50*
(2006.01)i, *H05B33/02*(2006.01)i, *F21Y105/00*(2006.01)n

According to International Patent Classification (IPC) or to both national classification and IPC

B.   FIELDS SEARCHED

Minimum documentation searched (classification system followed by classification symbols)
H05B33/04, G09F9/30, H01L27/32, H01L51/50, H05B33/02, F21Y105/00

Documentation searched other than minimum documentation to the extent that such documents are included in the fields searched
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X | JP 2000-323273 A  (Dainippon Printing Co., Ltd.), 24 November 2000 (24.11.2000), paragraphs [0080] to [0102]; fig. 1 to 3 (Family: none) | 1-6 |
| A | JP 2004-299230 A  (Dainippon Printing Co., Ltd.), 28 October 2004 (28.10.2004), paragraphs [0064] to [0094], [0121] & US 2005/0029513 A1     & US 2007/0059491 A1 | 1-6 |

☒   Further documents are listed in the continuation of Box C.          ☐   See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search 28 October, 2011 (28.10.11) | Date of mailing of the international search report 08 November, 2011 (08.11.11) |
|---|---|
| Name and mailing address of the ISA/ Japanese Patent Office | Authorized officer |
| Facsimile No. | Telephone No. |

Form PCT/ISA/210 (second sheet) (July 2009)

**INTERNATIONAL SEARCH REPORT**

| International application No. |
|---|
| PCT/JP2011/072885 |

C (Continuation).   DOCUMENTS CONSIDERED TO BE RELEVANT

| Category* | Citation of document, with indication, where appropriate, of the relevant passages | Relevant to claim No. |
|---|---|---|
| P,X | WO 2010/117046 A1  (Sumitomo Chemical Co., Ltd.), 14 October 2010 (14.10.2010), claims 1, 27; paragraphs [0090], [0097] to [0107] & JP 2010-260347 A     & JP 2011-73430 A | 1-6 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4089236 A

- JP 2002532850 PCT